# EUROPÄISCHE PATENTSCHRIFT

(11) **EP 2 311 111 B1**
(45) Veröffentlichungstag und Bekanntmachung des Hinweises auf die Patenterteilung: **19.09.2012**
(21) Anmeldenummer: 09777050.7
(22) Anmeldetag: 08.07.2009
(51) Int. Cl.: H01L 51/54

(54) **ORGANISCHE ELEKTROLUMINESZENZVORRICHTUNG**
ORGANIC ELECTROLUMINESCENCE DEVICE
DISPOSITIF ÉLECTROLUMINESCENT ORGANIQUE

(30) Priorität: 08.08.2008 DE 102008036982
(43) Veröffentlichungstag der Anmeldung: 20.04.2011
(73) Patentinhaber: Merck Patent GmbH, 64293 Darmstadt (DE)
(72) Erfinder: PARHAM, Amir, Hossain, 65929 Frankfurt (DE); KAISER, Joachim, 64293 Darmstadt (DE); GERHARD, Anja, 63329 Egelsbach (DE); KROEBER, Jonas, Valentin, 60311 Frankfurt (DE)
(86) Internationale Anmeldenummer: PCT/EP2009/004954
(87) Internationale Veröffentlichungsnummer: WO 2010/015306

(56) Entgegenhaltungen:
- WO-A-2005/053055
- WO-A-2008/086851
- SHEN J Y ET AL: "High Tg blue emitting materials for electroluminescent devices" JOURNAL OF MATERIALS CHEMISTRY, THE ROYAL SOCIETY OF CHEMISTRY, CAMBRIDGE, GB, Bd. 15, Nr. 25, 12. Mai 2005 (2005-05-12), Seiten 2455-2463, XP003011710 ISSN: 0959-9428
- LEE R H ET AL: "Efficient fluorescent red, green, and blue organic light-emitting devices with a blue host of spirobifluorene derivative" THIN SOLID FILMS, ELSEVIER-SEQUOIA S.A. LAUSANNE, CH, Bd. 516, Nr. 15, 2. Juni 2008 (2008-06-02), Seiten 5062-5068, XP022622347 ISSN: 0040-6090 [gefunden am 2008-02-19]

## Beschreibung

Die vorliegende Erfindung betrifft phosphoreszierende organische Elektrolumineszenzvorrichtungen, welche Fluoren- und Spirobifluorenderivate als Matrixmaterialien enthalten.

Organische Halbleiter werden für eine Reihe verschiedenartiger elektronischer Anwendungen entwickelt. Der Aufbau organischer Elektrolumineszenzvorrichtungen (OLEDs), in denen diese organischen Halbleiter als funktionelle Materialien eingesetzt werden, ist beispielsweise in US 4539507, US 5151629, EP 0676461 und WO 98/27136 beschrieben. Allerdings sind noch weitere Verbesserungen erforderlich. So gibt es insbesondere in Bezug auf die Lebensdauer, die Effizienz und die Betriebsspannung organischer Elektrolumineszenzvorrichtungen noch Verbesserungsbedarf. Weiterhin ist es erforderlich, dass die Verbindungen eine hohe thermische Stabilität und eine hohe Glasübergangstemperatur aufweisen und sich unzersetzt sublimieren lassen.

Gerade auch bei phosphoreszierenden Elektrolumineszenzvorrichtungen sind noch Verbesserungen der oben genannten Eigenschaften erforderlich. Insbesondere besteht Verbesserungsbedarf bei Matrixmaterialien für phosphoreszierende Emitter, die gleichzeitig zu guter Effizienz, hoher Lebensdauer und geringer Betriebsspannung führen. Gerade die Eigenschaften der Matrixmaterialien sind häufig limitierend für die Lebensdauer und die Effizienz der organischen Elektrolumineszenzvorrichtung.

Gemäß dem Stand der Technik werden häufig Carbazolderivate, z. B. Bis(carbazolyl)biphenyl, als Matrixmaterialien verwender siehe z.B. WO 2008/086851. Hier besteht noch Verbesserungsbedarf insbesondere in Bezug auf die Lebensdauer und die Glasübergangstemperatur der Materialien.

Weiterhin werden Ketone (WO 04/093207), Phosphinoxide und Sulfone (WO 05/003253) als Matrixmaterialien für phosphoreszierende Emitter verwendet. Insbesondere mit Ketonen werden niedrige Betriebsspannungen und lange Lebensdauern erzielt. Hier besteht noch Verbesserungsbedarf insbesondere in Bezug auf die Effizienz und die Kompatibilität mit Metallkomplexen, welche Ketoketonat-Liganden enthalten, beispielsweise Acetylacetonat.

Weiterhin werden Metallkomplexe, beispielsweise BAlq oder Bis[2-(2-benzothiazol)phenolat]-zink(II), als Matrixmaterialien für phosphoreszierende Emitter verwendet. Hier besteht noch Verbesserungsbedarf insbesondere in Bezug auf die Betriebsspannung und die chemische Stabilität. Rein organische Verbindungen sind häufig stabiler als diese Metallkomplexe. So sind einige dieser Metallkomplexe hydrolyseempfindlich, was die Handhabung der Komplexe erschwert.

Insbesondere besteht noch Verbesserungsbedarf bei Matrixmaterialien für phosphoreszierende Emitter, welche gleichzeitig zu hohen Effizienzen, langen Lebensdauern und geringen Betriebsspannungen führen und welche auch mit phosphoreszierenden Emittern, welche Ketoketonat-Liganden tragen, kompatibel sind.

Überraschend wurde gefunden, dass Fluorenderivate und entsprechende heterocyclische Derivate, welche mit Triazin oder anderen elektronenarmen Stickstoffheterocyclen substituiert sind, insbesondere Spirobifluorenderivate, sich sehr gut als Matrixmaterialien für phosphoreszierende Emitter eignen und in dieser Verwendung zu OLEDs führen, welche gleichzeitig hohe Effizienzen, lange Lebensdauern und geringe Betriebsspannungen aufweisen, auch mit phosphoreszierenden Emittern, welche Ketoketonatliganden enthalten.

In der US 6,229,012 und US 6,225,467 ist die Verwendung von Fluorenderivaten, welche mit Triazingruppen substituiert sind, als Elektronentransportmaterial in OLEDs offenbart. Es ist der Anmeldung jedoch nicht zu entnehmen, dass sich diese Materialien auch als Matrixmaterialien für phosphoreszierende Emitter eignen.

In der WO 05/053055 wird die Verwendung von Triazinderivaten, insbesondere von Spirobifluorenderivaten, welche mit Triazingruppen substituiert sind, als Lochblockiermaterial in phosphoreszierenden OLEDs offenbart. Es ist der Anmeldung jedoch nicht zu entnehmen, dass sich diese Materialien auch als Matrixmaterialien für phosphoreszierende Emitter eignen.

R.H. Lee et al., Thin Solid Films, 2008, 516 (15), 5062-5068 offenbart die Verwendung von Pyrimidin-substituierten Spirofluorenen als Lichemittierende Materialien in OLEDs.

Gegenstand der Erfindung ist somit eine organische Elektrolumineszenzvorrichtung enthaltend in mindestens einer emittierenden Schicht
(A) mindestens eine phosphoreszierende Verbindung, und
(B) mindestens eine Verbindung gemäß Formel (1) oder Formel (2), 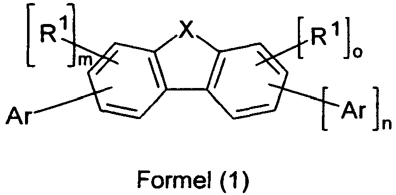 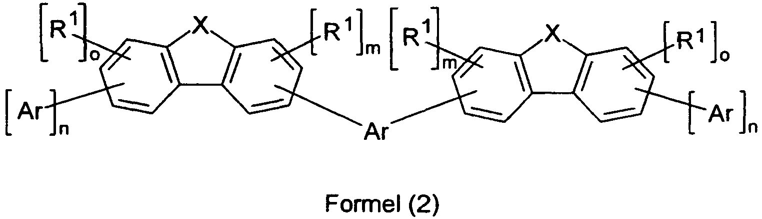 wobei für die verwendeten Symbole und Indizes gilt:
   - Ar: ist bei jedem Auftreten gleich oder verschieden eine Heteroarylgruppe, ausgewählt aus der Gruppe bestehend aus Triazin, Pyrazin, Pyrimidin, Pyridazin, Pyridin, Pyrazol, Imidazol, Oxazol, Oxadiazol oder Thiazol, welche jeweils mit einer oder mehreren Gruppen R¹ substituiert sein kann;
   - X: ist bei jedem Auftreten gleich oder verschieden eine Gruppe gemäß Formel (3), wobei die gestrichelte Bindung jeweils die Bindung an die beiden Benzolringe andeutet: 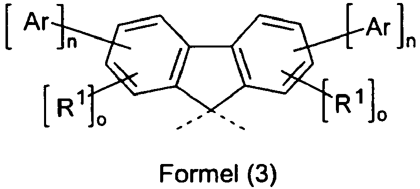 oder X ist gleich oder verschieden bei jedem Auftreten eine bivalente Brücke, ausgewählt aus B(R¹), C(R¹)₂, Si(R¹)₂, C=C(R¹)₂, O, S, S=O, SO₂, N(R¹), P(R¹) und P(=O)R¹;
   - R¹: ist bei jedem Auftreten gleich oder verschieden H, D, F, Cl, Br, I, CHO, N(Ar¹)₂, C(=O)Ar¹, P(=O)(Ar¹)₂, S(=O)Ar¹, S(=O)₂Ar¹, CR²=CR²Ar¹, CN, NO₂, Si(R²)₃, B(OR²)₂, B(R²)₂, B(N(R²)₂)₂, OSO₂R², eine geradkettige Alkyl-, Alkoxy- oder Thioalkoxygruppe mit 1 bis 40 C-Atomen oder eine geradkettige Alkenyl-oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere bevorzugt nicht benachbarte CH₂-Gruppen durch R²C=CR², C=C , Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Kombination dieser Systeme; dabei können zwei oder mehrere benachbarte Substituenten R¹ auch miteinander ein mono- oder polycyclisches, aliphatisches oder aromatisches Ringsystem bilden;
   - Ar¹: ist bei jedem Auftreten gleich oder verschieden ein aromatisches oder heteroaromatisches Ringsystem mit 5 bis 30 aromatischen Ringatomen, das mit einem oder mehreren Resten R² substituiert sein kann; dabei können auch zwei Reste Ar¹, welche an dasselbe Stickstoff-, Phosphor- oder Boratom binden, durch eine Einfachbindung oder eine Brücke, ausgewählt aus B(R²), C(R²)₂, Si(R²)₂, C=O, C=NR², C=C(R²)₂, O, S, S=O, SO₂, N(R²), P(R²) und P(=O)R², miteinander verknüpft sein;
   - R²: ist bei jedem Auftreten gleich oder verschieden H, D oder ein aliphatischer, aromatischer und/oder heteroaromatischer Kohlenwasserstoffrest mit 1 bis 20 C-Atomen, in dem auch H-Atome durch D oder F ersetzt sein können; dabei können zwei oder mehrere benachbarte Substituenten R² auch miteinander ein mono- oder polycyclisches, aliphatisches oder aromatisches Ringsystem bilden;
   - n: ist 0 oder 1;
   - m: ist 0, 1, 2 oder 3;
   - o: ist 0, 1, 2, 3 oder 4, wenn n = 0 ist und ist 0, 1, 2 oder 3, wenn n = 1 ist.

Unter einer organischen Elektrolumineszenzvorrichtung wird eine Vorrichtung verstanden, welche Anode, Kathode und mindestens eine emittierende Schicht, welche zwischen der Anode und der Kathode angeordnet ist, enthält, wobei mindestens eine Schicht zwischen der Anode und der Kathode mindestens eine organische bzw. metallorganische Verbindung enthält. Dabei enthält mindestens eine emittierende Schicht mindestens einen phosphoreszierenden Emitter und mindestens eine Verbindung der oben aufgeführten Formel (1) oder (2). Eine organische Elektrolumineszenzvorrichtung muss nicht notwendigerweise nur Schichten enthalten, welche aus organischen oder metallorganischen Materialien aufgebaut sind. So ist es auch möglich, dass eine oder mehrere Schichten anorganische Materialien enthalten oder ganz aus anorganischen Materialien aufgebaut sind.

Eine phosphoreszierende Verbindung im Sinne dieser Erfindung ist eine Verbindung, welche bei Raumtemperatur Lumineszenz aus einem angeregten Zustand mit höherer Spinmultiplizität zeigt, also einem Spinzustand > 1, insbesondere aus einem angeregten Triplettzustand. Im Sinne dieser Erfindung sollen insbesondere alle lumineszierenden Iridium- und Platinverbindungen als phosphoreszierende Verbindungen angesehen werden.

Eine Arylgruppe im Sinne dieser Erfindung enthält mindestens 6 C-Atome; eine Heteroarylgruppe im Sinne dieser Erfindung enthält mindestens 2 C-Atome und mindestens 1 Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Pyren, Chinolin, Isochinolin, etc., verstanden.

Ein aromatisches Ringsystem im Sinne dieser Erfindung enthält mindestens 6 C-Atome im Ringsystem. Ein heteroaromatisches Ringsystem im Sinne dieser Erfindung enthält mindestens 2 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nicht-aromatische Einheit (bevorzugt weniger als 10 % der von H verschiedenen Atome), wie z. B. ein sp³- oder sp²-hybridisiertes C-, N- oder O-Atom, unterbrochen sein können. So sollen beispielsweise auch Systeme wie 9,9'-Spirobifluoren, 9,9-Diarylflüoren, Triarylamin, Diarylether, Stilben, Benzophenon, etc. als aromatische Ringsysteme im Sinne dieser Erfindung verstanden werden. Ebenso werden unter einem aromatischen bzw. heteroaromatischen Ringsystem Systeme verstanden, in denen mehrere Aryl- bzw. Heteroarylgruppen durch Einfachbindungen miteinander verknüpft sind, beispielsweise Biphenyl, Terphenyl oder Bipyridin.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, *i*-Propyl, n-Butyl, *i*-Butyl, s-Butyl, *t*-Butyl, 2-Methylbutyl, *n*-Pentyl, *s*-Pentyl, *tert*-Pentyl, 2-Pentyl, Cyclopentyl, *n*-Hexyl, *s*-Hexyl, *t*-Hexyl, 2-Hexyl, 3-Hexyl, Cyclohexyl, 2-Methylpentyl, *n*-Heptyl, 2-Heptyl, 3-Heptyl, 4-Heptyl, Cycloheptyl, 1-Methylcyclohexyl, *n*-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer C₁- bis C₄₀-Alkoxygruppe werden besonders bevorzugt Methoxy, Trifluormethoxy, Ethoxy, *n*-Propoxy, *i*-Propoxy, *n*-Butoxy, *i*-Butoxy, *s*-Butoxy, *t*-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Benzanthracen, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Benzofluoren, Dibenzofluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt weisen die Verbindungen gemäß Formel (1) und (2) eine Glasübergangstemperatur T_{G} von größer als 70 °C auf, besonders bevorzugt größer als 90 °C, ganz besonders bevorzugt größer als 110 °C.

In einer bevorzugten Ausführungsform der Erfindung steht die Gruppe X gleich oder verschieden bei jedem Auftreten für eine Gruppe gemäß Formel (3) oder für eine bivalente Brücke ausgewählt aus C(R¹)₂, Si(R¹)₂ und NR¹. In einer besonders bevorzugten Ausführungsform der Erfindung steht die Gruppe X für eine Gruppe gemäß Formel (3) oder für C(R¹)₂.

Die Verbindung gemäß Formel (1) ist also besonders bevorzugt entweder ein Spirobifluorenderivat, wenn die Gruppe X für eine Gruppe gemäß Formel (3) steht, oder sie ist ein Fluorenderivat, wenn die die Gruppe X für C(R¹)₂ steht. Ebenso ist die Verbindung gemäß Formel (2) besonders bevorzugt ein Spirobifluorenderivat, ein Fluorenderivat oder eine Verbindung, welche eine Spirobifluorengruppe und eine Fluorengruppe enthält. Eine besonders bevorzugte Ausführungsform der Erfindung sind daher die Fluorenderivate gemäß den Formeln (4) und (5) und die Spirobifluorenderivate gemäß den Formeln (6) und (7), 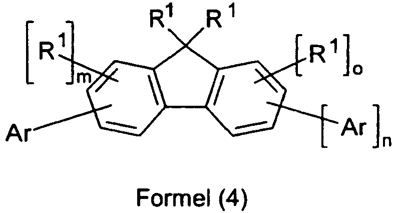 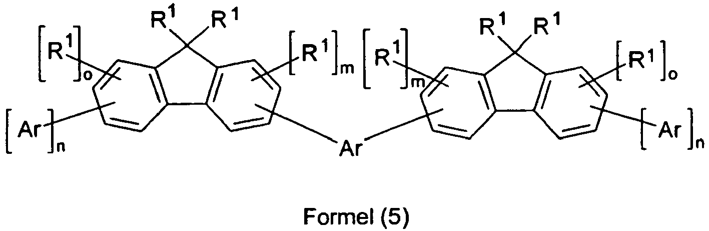 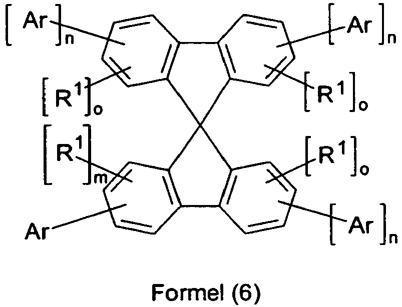 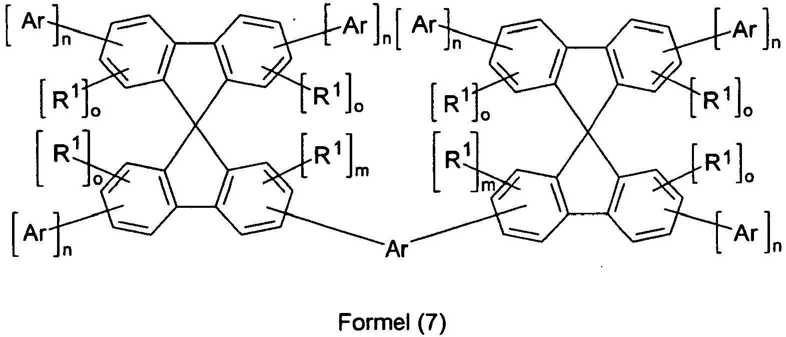 wobei die verwendeten Symbole und Indizes dieselben Bedeutungen haben, wie oben beschrieben.

Die Gruppe Ar stellt einen elektronenarmen Heteroaromaten dar. Bevorzugt steht die Gruppe Ar gleich oder verschieden bei jedem Auftreten für einen 6-Ring-Heteroaromaten, also für Triazin, Pyrazin, Pyrimidin, Pyridazin oder Pyridin, welcher jeweils mit einem oder mehreren Resten R¹ substituiert sein kann.

In einer bevorzugten Ausführungsform der Erfindung ist die monovalente Gruppe Ar in Verbindungen der Formeln (1), (2) und (4) bis (7) ausgewählt aus den Gruppen gemäß den folgenden Formeln (8) bis (20), wobei die gestrichelte Bindung jeweils die Bindung der Gruppe an das Fluoren bzw. das Spirobifluoren bzw. an das entsprechende heterocyclische Derivat andeutet und R¹ dieselbe Bedeutung hat, wie oben beschrieben:

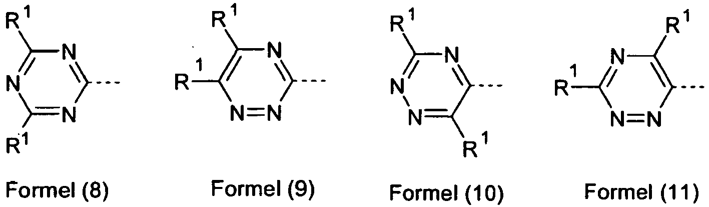

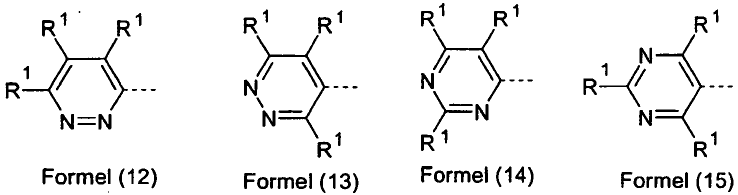

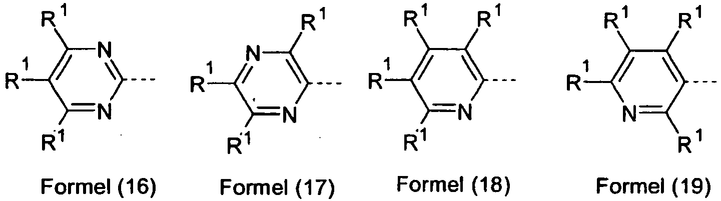

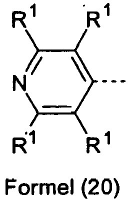

In einer bevorzugten Ausführungsform der Erfindung ist die bivalente Gruppe Ar in Verbindungen der Formeln (2) und (7) ausgewählt aus den Gruppen gemäß den folgenden Formeln (21) bis (28), wobei die gestrichelten Bindungen jeweils die Bindung der Gruppe an das Fluoren bzw. das Spirobifluoren bzw. das entsprechende heterocyclische Derivat andeuten und R¹ dieselbe Bedeutung hat, wie oben beschrieben:

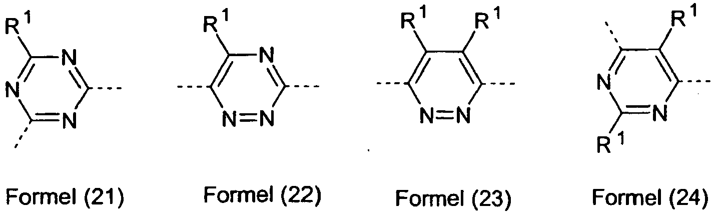

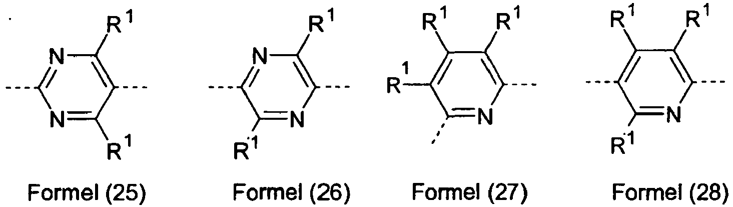

In einer bevorzugten Ausführungsform der Erfindung enthält die Gruppe Ar zwei oder drei Stickstoffatome. Bevorzugte monovalente Gruppen Ar sind daher die Gruppen der Formeln (8) bis (17), und bevorzugte bivalente Gruppen Ar sind die Gruppen der Formeln (21) bis (26). Besonders bevorzugt enthält die Gruppe Ar drei Stickstoffatome. Besonders bevorzugte monovalente Gruppen Ar sind daher die Gruppen der Formeln (8) bis (11), insbesondere die Gruppe gemäß Formel (8), und besonders bevorzugte bivalente Gruppen Ar sind die Gruppen der Formeln (21) und (22), insbesondere die Gruppe gemäß Formel (21).

In nochmals einer bevorzugten Ausführungsform der Erfindung steht der Rest R¹, welcher an die Gruppen der Formeln (8) bis (28) gebunden ist, gleich oder verschieden bei jedem Auftreten für H, D, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 30 aromatischen Ringatomen, das jeweils durch einen oder mehrere Reste R² substituiert sein kann, oder eine Kombination dieser Systeme. In einer besonders bevorzugten Ausführungsform der Erfindung steht der Rest R¹, welcher an die Gruppen der Formeln (8) bis (28) gebunden ist, gleich oder verschieden bei jedem Auftreten für H oder D, eine geradkettige Alkylgruppe mit 1 bis 5 C-Atomen oder eine verzweigte oder cyclische Alkylgruppe mit 3 bis 6 C-Atomen, die jeweils mit einem oder mehreren Resten R² substituiert sein kann, wobei ein oder mehrere H-Atome durch D oder F ersetzt sein können, oder für ein aromatisches oder heteroaromatisches Ringsystem mit 5 bis 25 aromatischen Ringatomen, das jeweils durch einen oder mehrere Reste R² substituiert sein kann, oder eine Kombination dieser Systeme. Ganz besonders bevorzugt steht der Rest R¹, welcher an die Gruppen der Formeln (8) bis (28) gebunden ist, gleich oder verschieden bei jedem Auftreten für H oder D oder für ein aromatisches oder heteroaromatisches Ringsystem mit 5 bis 14 aromatischen Ringatomen, das jeweils durch einen oder mehrere Reste R² substituiert sein kann, insbesondere für Phenyl, Naphthyl oder Biphenyl, welches jeweils durch einen oder mehrere Reste R² substituiert sein kann, jedoch bevorzugt unsubstituiert ist.

In nochmals einer bevorzugten Ausführungsform der Erfindung steht der Rest R¹, welcher direkt an das Fluoren bzw. Spirobifluoren bzw. die entsprechende heterocyclische Verbindung gebunden ist, gleich oder verschieden bei jedem Auftreten für H, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, wobei ein oder mehrere H-Atome durch D oder F ersetzt sein können, oder ein aromatisches oder heteroaromatisches Ringsystem mit 5 bis 30 aromatischen Ringatomen, das jeweils durch einen oder mehrere Reste R² substituiert sein kann, oder eine Kombination dieser Systeme. In einer besonders bevorzugten Ausführungsform der Erfindung steht der Rest R¹, welcher direkt an das Fluoren bzw. Spirobifluoren bzw. die entsprechende heterocyclische Verbindung gebunden ist, gleich oder verschieden bei jedem Auftreten für H, eine geradkettige Alkylgruppe mit 1 bis 5 C-Atomen oder eine verzweigte oder cyclische Alkylgruppe mit 3 bis 6 C-Atomen, die jeweils mit einem oder mehreren Resten R² substituiert sein kann, wobei ein oder mehrere H-Atome durch D oder F ersetzt sein können, oder für ein aromatisches oder heteroaromatisches Ringsystem mit 5 bis 25 aromatischen Ringatomen, das jeweils durch einen oder mehrere Reste R² substituiert sein kann.

In einer weiteren bevorzugten Ausführungsform der Erfindung ist die Gruppe Ar in 2-Position des Fluorens bzw. Spirobifluorens bzw. des entsprechenden Heterocyclus gebunden. Falls mehr als eine Gruppe Ar vorhanden ist, sind die anderen Gruppen Ar bevorzugt in 7-Position und in Spirobifluorenderivaten auch in der 2'-Position und 7'-Position gebunden. Besonders bevorzugte Verbindungen gemäß Formel (1), (2) und (4) bis (7) sind daher die Verbindungen gemäß den Formeln (29) bis (32), 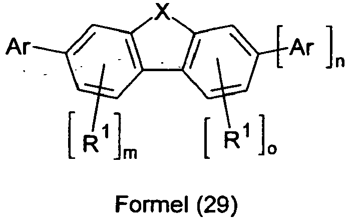 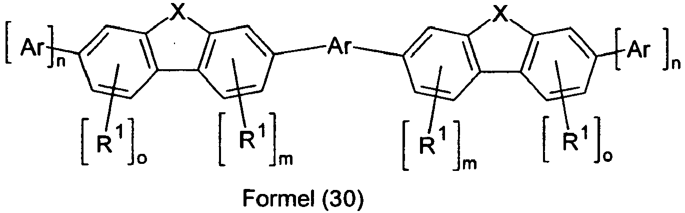 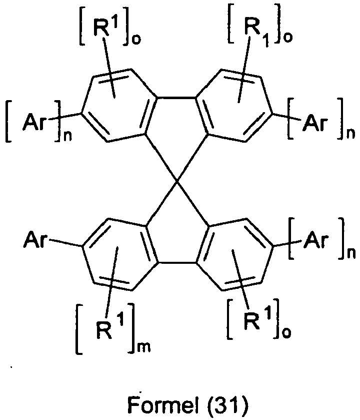 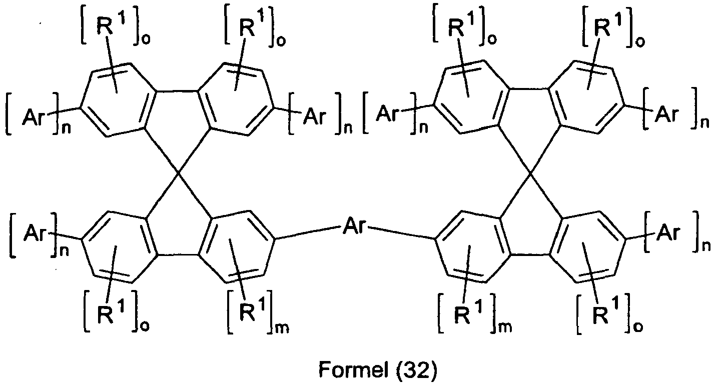 wobei die Symbole und Indizes dieselbe Bedeutung haben, wie oben beschrieben und wobei für n = 0 in der entsprechenden Position auch ein Substituent R¹ gebunden sein kann. Eine bevorzugte Ausführungsform der Verbindungen gemäß Formel (29) und (30) sind Verbindungen, in denen X für C(R¹)₂ steht.

In einer bevorzugten Ausführungsform von Verbindungen gemäß Formel (1), (2), (4) bis (7) und (29) bis (32) ist der Index m = 0, d. h. außer der Gruppe Ar ist an diesem Benzolring kein weiterer Substituent gebunden.

In einer weiteren bevorzugten Ausführungsform von Verbindungen gemäß Formel (1), (2), (4) bis (7) und (29) bis (32) ist an jedem Benzolring die Summe der Indizes n + o = 0 oder 1, d. h. an jeden Benzolring ist maximal eine Gruppe Ar oder maximal ein Rest R¹ gebunden.

Bevorzugte Ausführungsformen der Verbindungen gemäß Formel (29) bis (32) sind Verbindungen, in denen die Gruppe Ar für eine Gruppe gemäß den vorne aufgeführten Formeln (8) bis (28) steht.

In einer ganz besonders bevorzugten Ausführungsform der Erfindung steht in den Verbindungen gemäß Formel (29) bis (32) die Gruppe Ar für eine Gruppe gemäß Formel (8) bzw. Formel (21). Besonders bevorzugt ist weiterhin in diesen Verbindungen m = 0 und n + o = 0 oder 1 an jedem Benzolring. Ganz besonders bevorzugt sind daher die Verbindungen gemäß den Formeln (33) bis (36), 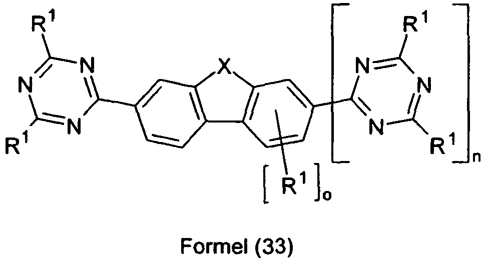 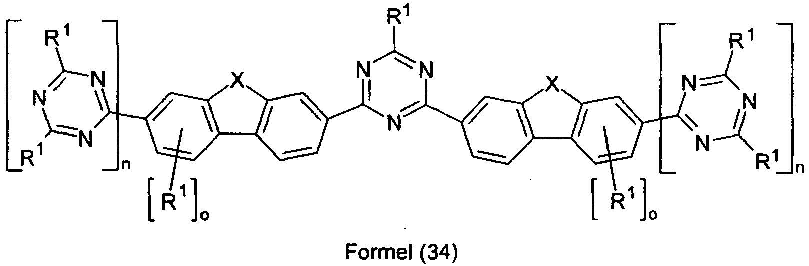 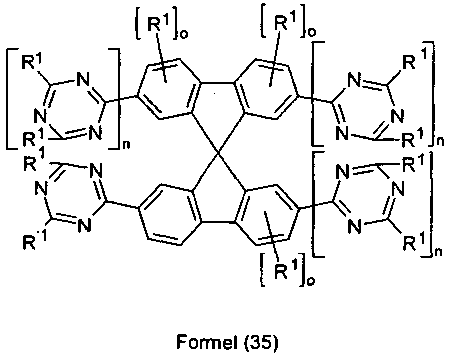 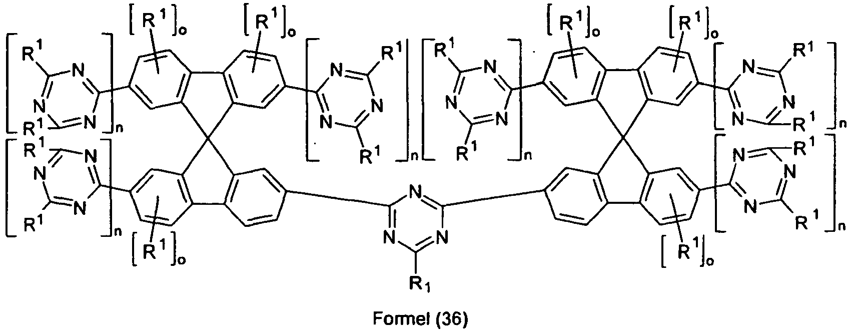 wobei die verwendeten Symbole und Indizes die oben genannten Bedeutungen haben und weiterhin gilt, dass an jedem Benzolring n + o = 0 oder 1 ist und wobei der Rest R¹ für n = 0 und o = 1 an jeder beliebigen freien Stelle des Benzolrings gebunden sein kann. Bevorzugte Ausführungsformen für Verbindungen gemäß Formel (33) und (34) sind solche, in denen X für C(R¹)₂ steht.

Besonders bevorzugt sind die Spirobifluorenderivate der Formeln (35) und (36), insbesondere das Spirobifluorenderivat der Formel (35). Ganz besonders bevorzugt enthalten die Verbindungen gemäß Formel (35) eine oder zwei Triazingruppen. Die Verbindungen gemäß Formel (35) sind also besonders bevorzugt ausgewählt aus Verbindungen gemäß Formel (37), (38) und (39), 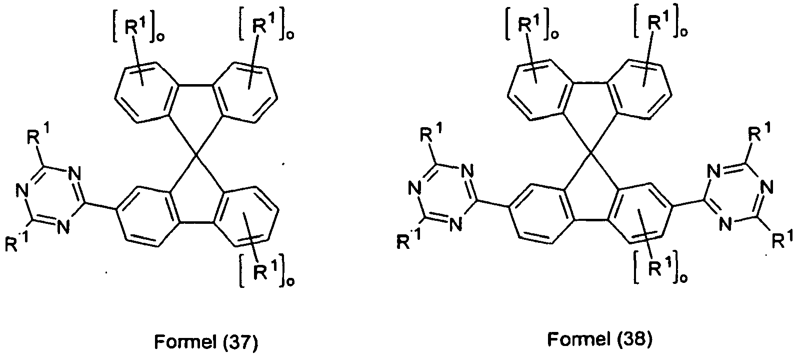 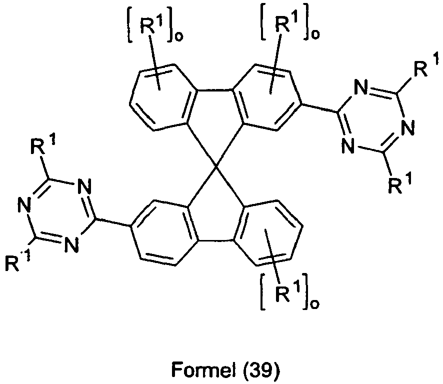 wobei die verwendeten Symbole die oben genannten Bedeutungen haben und o gleich oder verschieden bei jedem Auftreten für 0 oder 1 steht.

Beispiele für bevorzugte Verbindungen gemäß den Formeln (1), (2), (4) bis (7) und (29) bis (39) sind die im Folgenden abgebildeten Strukturen (1) bis (96).

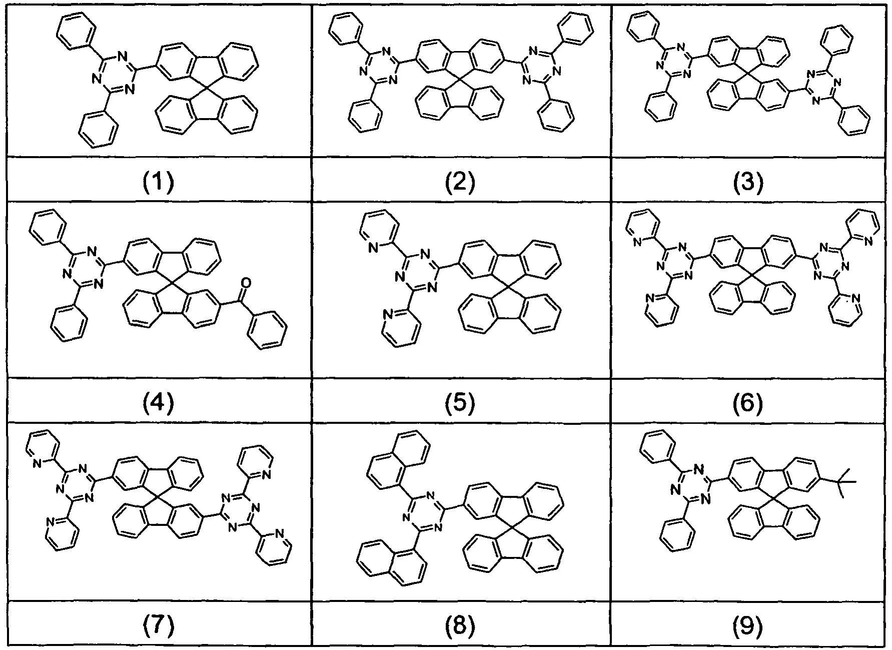

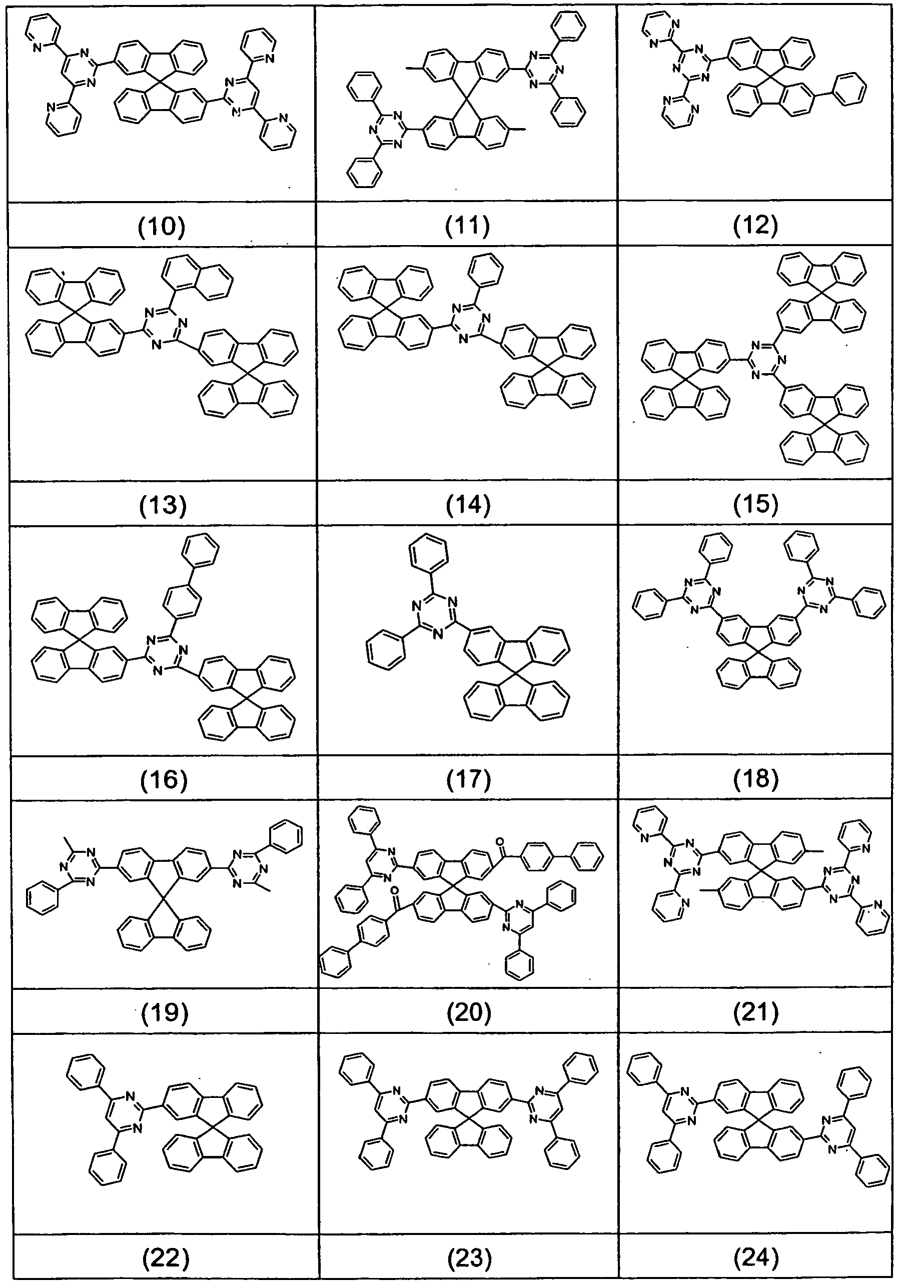

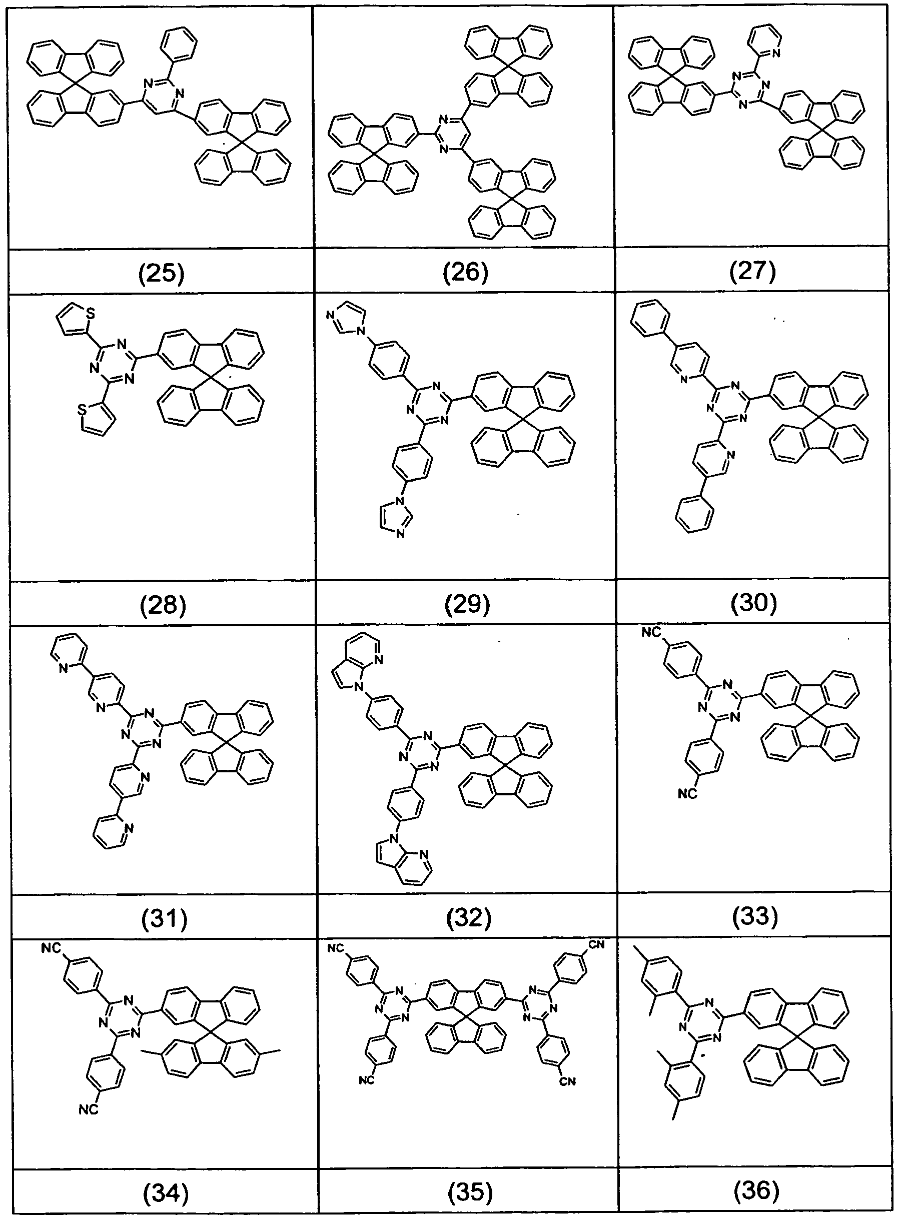

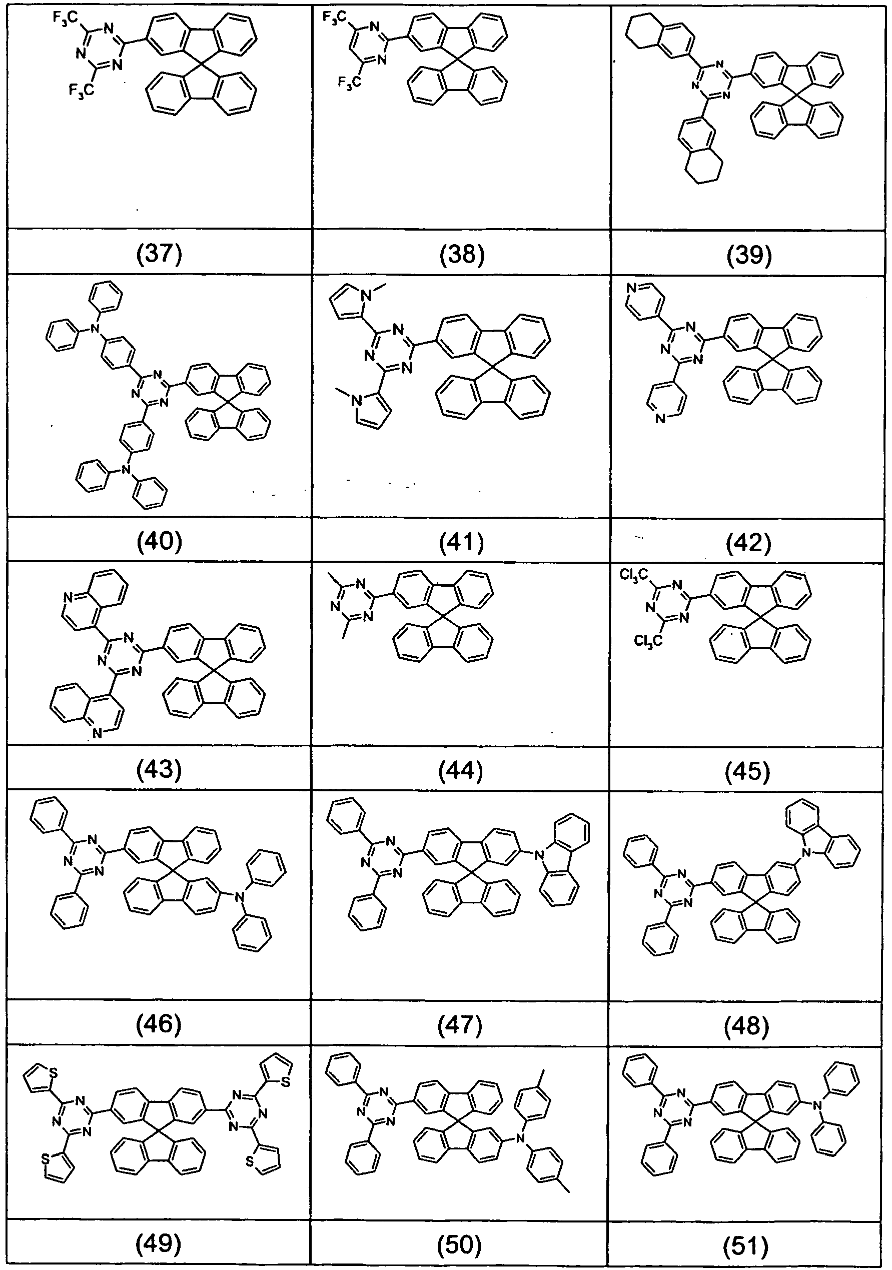

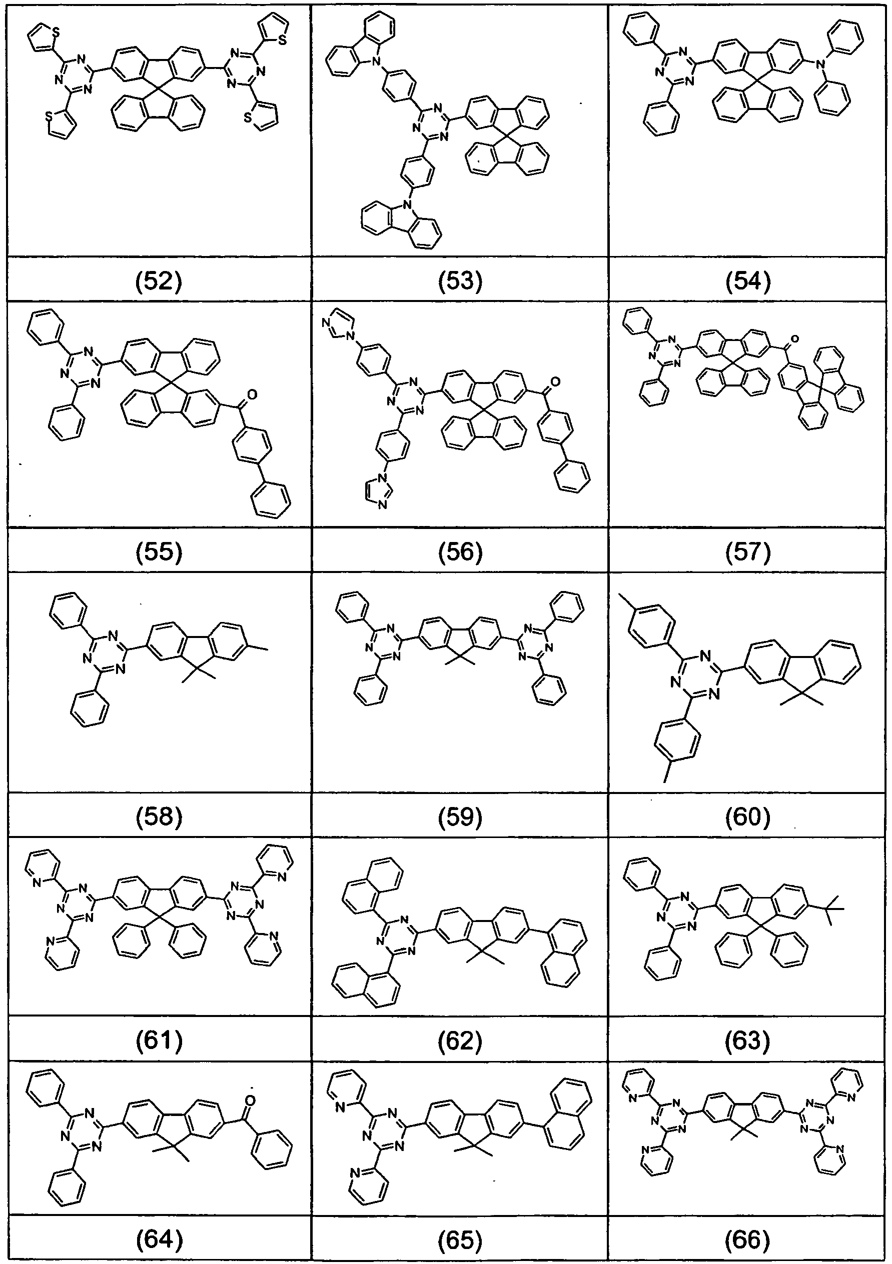

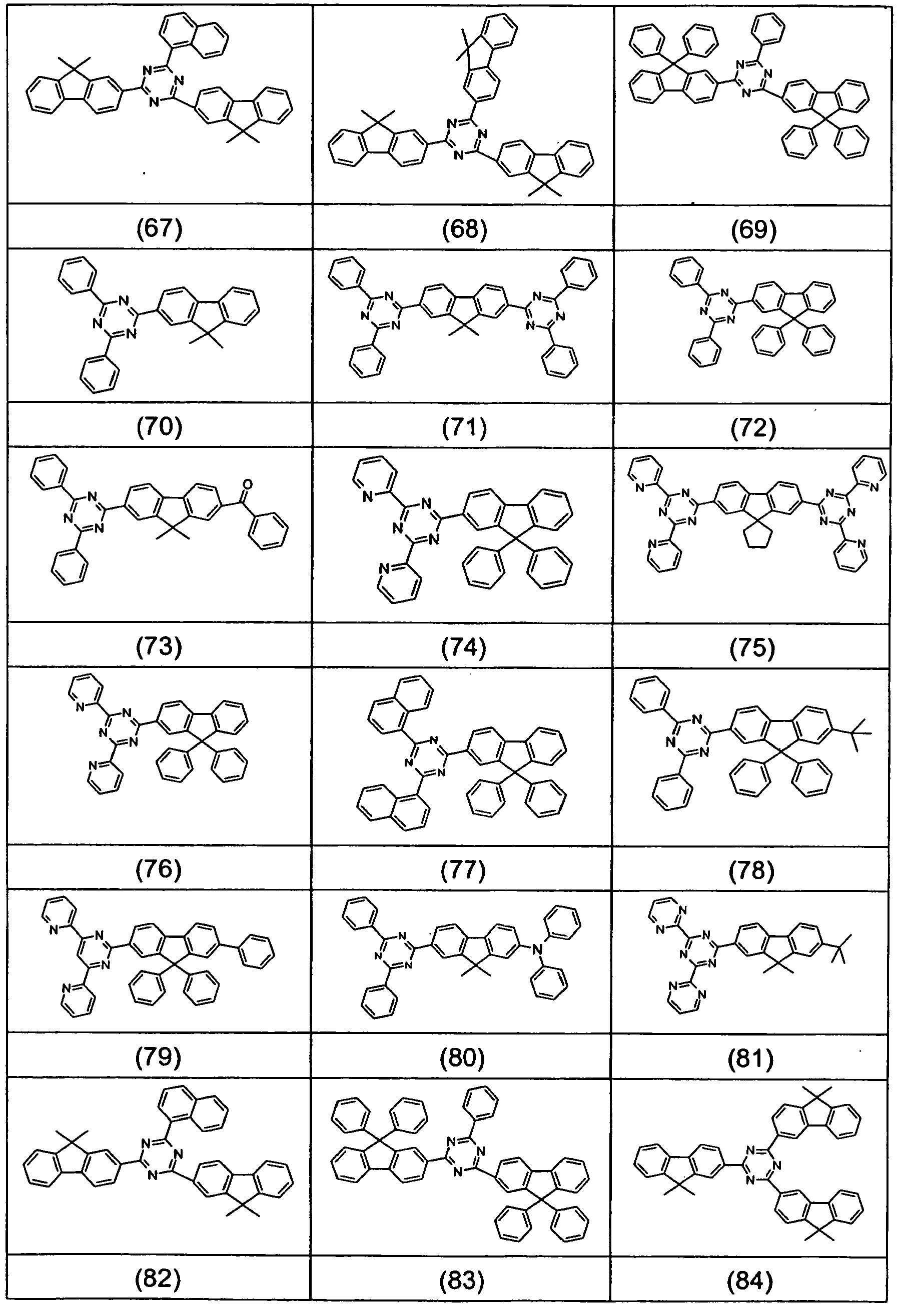

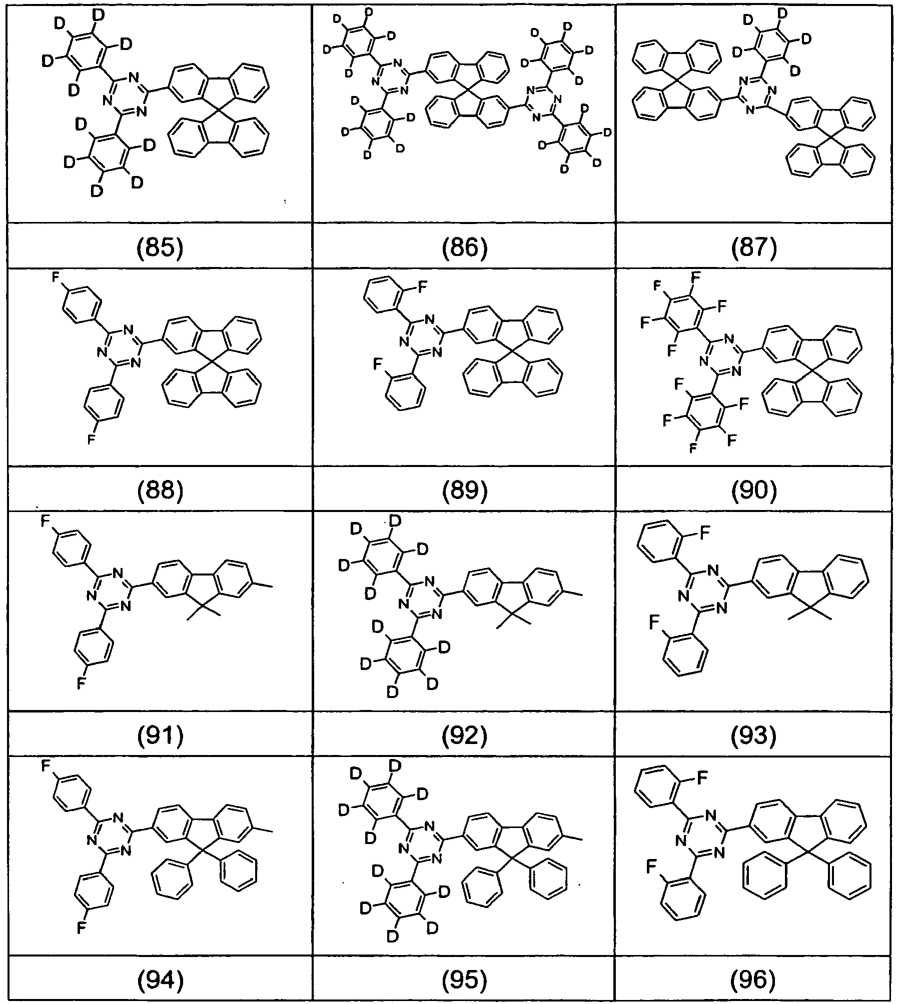

Die Verbindungen gemäß Formel (1) können beispielsweise gemäß den in US 6,229,012, US 6,225,467 und WO 05/053055 beschriebenen Verfahren synthetisiert werden. Allgemein eignen sich metallkatalysierte Kupplungsreaktionen zur Synthese der Verbindungen, insbesondere die Suzuki-Kupplung, wie im folgenden Schema 1 am Beispiel des Triazins dargestellt. So kann ein Fluoren, Spirobifluoren oder anderes heterocyclisches Derivat, welches jeweils mit einer Boronsäure oder einem Boronsäurederivat substituiert ist, unter Palladium-Katalyse mit der Gruppe Ar gekuppelt werden, welche für Verbindungen gemäß Formel (1) mit einer reaktiven Abgangsgruppe und für Verbindungen gemäß Formel (2) mit zwei reaktiven Abgangsgruppen substituiert ist. Geeignete reaktive Abgangsgruppen sind beispielsweise Halogene, insbesondere Chlor, Brom und lod, Triflat oder Tosylat.

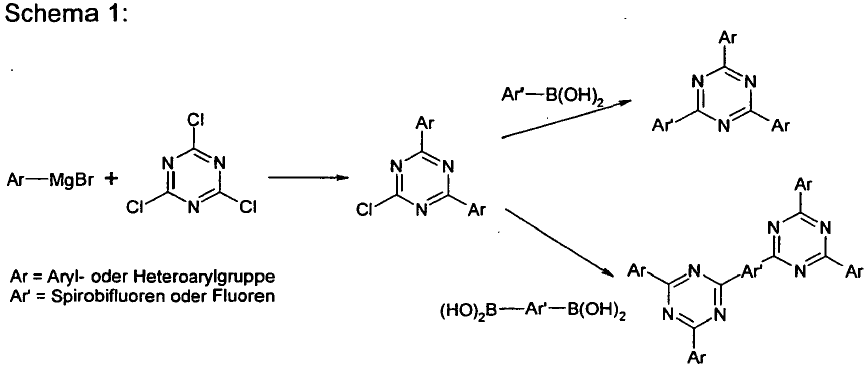

Wie oben beschrieben, werden die Verbindungen gemäß den Formeln (1) und (2) als Matrixmaterialien für phosphoreszierende Emitter verwendet.

Als phosphoreszierende Verbindungen eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten.

Besonders bevorzugte organische Elektrolumineszenzvorrichtungen enthalten als phosphoreszierenden Emitter mindestens eine Verbindung der Formeln (40) bis (43), 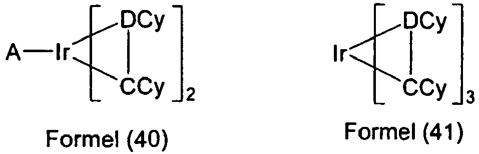 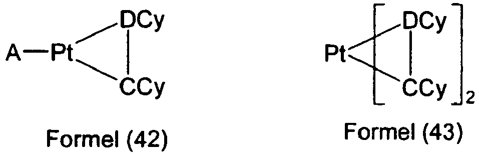 wobei R¹ dieselbe Bedeutung hat, wie oben für Formel (1) und (2) beschrieben, und für die weiteren verwendeten Symbole gilt:
- DCy: ist gleich oder verschieden bei jedem Auftreten eine cyclische Gruppe, die mindestens ein Donoratom, bevorzugt Stickstoff, Kohlenstoff in Form eines Carbens oder Phosphor, enthält, über welches die cyclische Gruppe an das Metall gebunden ist, und die wiederum einen oder mehrere Substituenten R¹ tragen kann; die Gruppen DCy und CCy sind über eine kovalente Bindung miteinander verbunden;
- CCy: ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹ tragen kann;
- A: ist gleich oder verschieden bei jedem Auftreten ein monoanionischer, zweizähnig chelatisierender Ligand, bevorzugt ein Diketonatligand.

Dabei kann durch Bildung von Ringsystemen zwischen mehreren Resten R¹ auch eine Brücke zwischen den Gruppen DCy und CCy vorliegen.

Beispiele der oben beschriebenen Emitter können den Anmeldungen WO 00/70655, WO 01/41512, WO 02/02714, WO 02/15645, EP 1191613, EP 1191612, EP 1191614 und WO 05/033244 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Außer Kathode, Anode und einer oder mehreren emittierenden Schichten kann die organische Elektrolumineszenzvorrichtung noch weitere schichten enthalten. Diese sind beispielsweise gewählt aus jeweils einer oder mehreren Lochinjektionsschichten, Lochtransportschichten, Lochblockierschichten, Elektronentransportschichten, Elektroneninjektionsschichten, Elektronenblockierschichten, Excitonenblockierschichten, Ladungserzeugungsschichten (=Charge-Generation Layers, IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer) und/oder organischen oder anorganischen p/n-Übergängen. Außerdem können Interlayers vorhanden sein, welche die Ladungsbalance im Device steuern. Weiterhin können die Schichten, insbesondere die Ladungstransportschichten, auch dotiert sein. Die Dotierung der Schichten kann für einen verbesserten Ladungstransport vorteilhaft sein. Es sei aber darauf hingewiesen, dass nicht notwendigerweise jede dieser Schichten vorhanden sein muss und die Wahl der Schichten immer von den verwendeten Verbindungen abhängt.

In einer weiteren bevorzugten Ausführungsform der Erfindung enthält die organische Elektrolumineszenzvorrichtung mehrere emittierende Schichten, wobei mindestens eine emittierende Schicht mindestens eine Verbindung gemäß Formel (1) oder Formel (2) und mindestens einen phosphoreszierenden Emitter enthält. Besonders bevorzugt weisen diese Emissionsschichten insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können und die blaues und gelbes, orange oder rotes Licht emittieren. Insbesondere bevorzugt sind Dreischichtsysteme, also Systeme mit drei emittierenden Schichten, wobei mindestens eine dieser Schichten mindestens eine Verbindung gemäß Formel (1) oder Formel (2) und mindestens einen phosphoreszierenden Emitter enthält und wobei die drei Schichten blaue, grüne und orange oder rote Emission zeigen (für den prinzipiellen Aufbau siehe z. B. WO 05/011013). Auch die Verwendung von mehr als drei emittierenden Schichten kann bevorzugt sein. Ebenso eignen sich für weiße Emission Emitter, welche breitbandige Emissionsbanden aufweisen und dadurch weiße Emission zeigen.

Die emittierende Schicht, welche die Mischung aus der Verbindung gemäß Formel (1) bzw. Formel (2) und dem phosphoreszierenden Emitter enthält, enthält bevorzugt zwischen 99 und 50 Vol.-%, vorzugsweise zwischen 98 und 50 Vol.-%, besonders bevorzugt zwischen 97 und 60 Vol.-%, insbesondere zwischen 95 und 85 Vol.-% der Verbindung gemäß Formel (1) bzw. Formel (2) bezogen auf die Gesamtmischung aus Emitter und Matrixmaterial. Entsprechend enthält die Mischung zwischen 1 und 50 Vol.-%, vorzugsweise zwischen 2 und 50 Vol.%, besonders bevorzugt zwischen 3 und 40 Vol.-%, insbesondere zwischen 5 und 15 Vol.-% des phosphoreszierenden Emitters bezogen auf die Gesamtmischung aus Emitter und Matrixmaterial.

Bevorzugt ist weiterhin auch die Verwendung mehrerer Matrixmaterialien als Mischung, wobei ein Matrixmaterial ausgewählt ist aus Verbindungen der Formel (1) oder (2). Die Verbindungen gemäß Formel (1) und Formel (2) haben überwiegend elektronentransportierende Eigenschaften durch die elektronenarmen Stickstoffheterocyclen Ar. Wenn eine Mischung aus zwei oder mehr Matrixmaterialien verwendet wird, ist daher eine weitere Komponente der Mischung bevorzugt eine lochtransportierende Verbindung. Bevorzugte lochleitende Matrixmaterialien sind Triarylamine, Carbazolderivate, z. B. CBP (N,N-Biscarbazolylbiphenyl) oder die in WO 05/039246, US 2005/0069729, JP 2004/288381, EP 1205527 oder WO 08/086851 offenbarten Carbazolderivate, Azacarbazole, z. B. gemäß EP 1617710, EP 1617711, EP 1731584, JP 2005/347160, bipolare Matrixmaterialien, z. B. gemäß WO 07/137725, und 9,9-Diarylfluorenderivate, z. B. gemäß der nicht offen gelegten Anmeldung DE 102008017591.9. Die Mischung der Matrixmaterialien kann auch mehr als zwei Matrixmaterialien enthalten. Es ist weiterhin auch möglich, das Matrixmaterial gemäß Formel (1) bzw. Formel (2) als Mischung mit einem weiteren elektronentransportierenden Matrixmaterial zu verwenden. Bevorzugte weitere elektronentransportierende Matrixmaterialien sind Ketone, z. B. gemäß WO 04/093207, Tetraarylketone, z. B. gemäß DE 102008033943.1, Phosphinoxide, Sulfoxide und Sulfone, z. B. gemäß WO 05/003253, Oligophenylene, bipolare Matrixmaterialien, z. B. gemäß WO 07/137725, Silane, z. B. gemäß WO 05/111172, 9,9-Diarylfluorenderivate (z. B. gemäß der nicht offen gelegten Anmeldung DE 102008017591.9), Azaborole oder Boronester (z. B. gemäß WO 06/117052).

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es sei jedoch angemerkt, dass der Druck auch noch geringer sein kann, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig. Hohe Löslichkeit lässt sich durch geeignete Substitution der Verbindungen erreichen. Dabei können nicht nur Lösungen aus einzelnen Materialien aufgebracht werden, sondern auch Lösungen, die mehrere Verbindungen enthalten, beispielsweise Matrixmaterialien und Dotanden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) oder (2) und einen phosphoreszierenden Dotanden aus Lösung aufzubringen und darauf eine Lochblockierschicht und/oder eine Elektronentransportschicht im Vakuum aufzudampfen. Ebenso kann die emittierende Schicht enthaltend eine Verbindung gemäß Formel (1) oder (2) und einen phosphoreszierenden Dotanden im Vakuum aufgedampft werden und eine oder mehrere andere Schichten können aus Lösung aufgebracht werden.

Diese Verfahren sind dem Fachmann generell bekannt und können von ihm ohne Probleme auf organische Elektrolumineszenzvorrichtungen enthaltend Verbindungen gemäß Formel (1) oder (2) bzw. die oben aufgeführten bevorzugten Ausführungsformen angewandt werden.

Ein weiterer Gegenstand der vorliegenden Erfindung sind Mischungen, enthaltend mindestens einen phosphoreszierenden Emitter und mindestens eine Verbindung gemäß Formel (1) oder Formel (2).

Ein weiterer Gegenstand der Erfindung sind Lösungen enthaltend eine Mischung aus mindestens einem phosphoreszierenden Emitter und mindestens einer Verbindung gemäß Formel (1) oder Formel (2) sowie mindestens ein organisches Lösungsmittel.

Nochmals ein weiterer Gegenstand der vorliegenden Erfindung ist die Verwendung von Verbindungen gemäß Formel (1) oder Formel (2) als Matrixmaterial für phosphoreszierende Emitter in einer organischen Elektrolumineszenzvorrichtung.

Die erfindungsgemäßen organischen Elektrolumineszenzvorrichtungen folgende überraschende Vorteile gegenüber dem Stand der Technik auf:
1. Die erfindungsgemäßen organischen Elektrolumineszenzvorrichtungen weisen eine sehr hohe Effizienz auf.
2. Die erfindungsgemäßen organischen Elektrolumineszenzvorrichtungen weisen gleichzeitig eine verbesserte Lebensdauer auf.
3. Die erfindungsgemäßen organischen Elektrolumineszenzvorrichtungen weisen gleichzeitig eine verringerte Betriebsspannung auf.
4. Die oben genannten verbesserten Eigenschaften der organischen Elektrolumineszenzvorrichtungen werden nicht nur mit tris-orthometallierten Metallkomplexen erhalten, sondern insbesondere auch mit Komplexen, welche noch einen Ketoketonat-Liganden, z. B. Acetylacetonat, enthalten. Matrixmaterialien gemäß dem Stand der Technik zeigen gerade für derartige Komplexe noch Verbesserungsbedarf in Bezug auf Effizienz, Lebensdauer und Betriebsspannung.

Die Erfindung wird durch die nachfolgenden Beispiele genauer beschrieben, ohne sie dadurch einschränken zu wollen. Der Fachmann kann, ohne erfinderisch tätig zu werden, weitere erfindungsgemäße Verbindungen herstellen und diese in organischen elektronischen Vorrichtungen verwenden.

### Beispiele:

Die nachfolgenden Synthesen werden, sofern nicht anders angegeben, unter einer Schutzgasatmosphäre in getrockneten Lösungsmitteln durchgeführt. Die Edukte können von ALDRICH (Kaliumfluorid (sprühgetrocknet), Tri-*tert*-butylphosphin, Palladium(II)acetat) bezogen werden. 3-Chlor-5,6-diphenyl-1,2,4-triazin kann analog zu EP 577559 dargestellt werden. 2',7'-Di-*tert*-butyl-spiro-9,9'-bifluoren-2,7-bisboronsäureglycolester kann nach WO 02/077060 und 2-Chlor-4,6-diphenyl-1,3,5-triazin nach US 5,438138 dargestellt werden. Spiro-9,9'-bifluoren-2,7-bis(boronsäureglycolester) kann analog zu WO 02/077060 dargestellt werden.

### Beispiel 1: Synthese von 2,7-Bis(4,6-diphenyl-1,3,5-triazin-2-yl)-2',7'-di-tert-butyl-spiro-9,9'-bifluoren (TRIAZIN1)

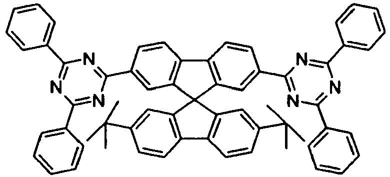

28.4 g (50.0 mmol) 2',7'-Di-*tert*-butyl-spiro-9,9'-bifluoren-2,7-bisboronsäureglycolester, 29.5 g (110.0 mmol) 2-Chlor-4,6-diphenyl-1,3,5-triazin und 44.6 g (210.0 mmol) Trikaliumphosphat werden in 500 mL Toulol, 500 mL Dioxan und 500 mL Wasser suspendiert. Zu dieser Suspension werden 913 mg (3.0 mmol) Tri-o-tolylphosphin und dann 112 mg (0.5 mmol) Patladium(II)acetat gegeben, und die Reaktionsmischung wird 16 h unter Rückfluss erhitzt. Nach Erkalten wird die organische Phase abgetrennt, über Kieselgel filtriert, dreimal mit 200 mL Wasser gewaschen und anschließend zur Trockene eingeengt. Der Rückstand wird aus Toluol und aus Dichlormethan / *iso*-Propanol umkristallisiert und abschließend im Hochvakuum (p = 5 x 10⁻⁵ mbar, T = 385 °C) sublimiert. Die Ausbeute beträgt 39.9 g (44.8 mmol), entsprechend 89.5 % der Theorie.

### Beispiel 2: Synthese von 2,7-Bis(4,6-diphenyl-1,3,5-triazin-2-yl)-spiro-9,9'-bifluoren (TRIAZIN2)

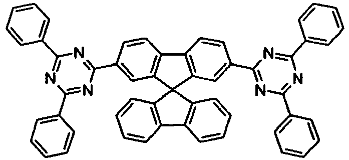

Die Synthese wird analog Beispiel 1 durchgeführt, wobei der 2',7'-Di-*tert-*butyl-spiro-9,9'-bifluoren-2,7-bis(boronsäureglycolester) durch 22.8 g (50 mmol) Spiro-9,9'-bifluoren-2,7-bis(boronsäureglycolester) ersetzt wird. Die Ausbeute beträgt 32.3 g (41.5 mmol), entsprechend 82.9 % der Theorie.

### Beispiel 3: Synthese von 2-(4,6-diphenyl-1,3,5-triazin-2-yl)spiro-9,9'-bifluoren (TRIAZIN3)

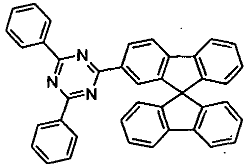

### a) Synthese von Spiro-9,9'-bifluoren-2-boronsäure

Eine auf -78 °C gekühlte Lösung von 71 g (180 mmol) 2-Brom-9-spirobifluoren in 950 ml Diethylether wird tropfenweise mit 73.7 ml (184 mmol) n-Buthyllithium (2.5 M in Hexan) versetzt. Die Reaktionsmischung wird 30 min. bei -78 °C gerührt. Man lässt auf Raumtemperatur kommen, kühlt erneut auf -78 °C und versetzt dann schnell mit einer Mischung von 26.4 ml (234 mmol) Trimethylborat in 50 ml Diethylether. Nach Erwärmen auf -10 °C wird mit 90 ml 2 N Salzsäure hydrolysiert. Die organische Phase wird abgetrennt, mit Wasser gewaschen, über Natriumsulfat getrocknet und zur Trockene eingeengt. Der Rückstand wird in 200 ml n-Heptan aufgenommen, der farblose Feststoff wird abgesaugt, mit n-Heptan gewaschen und im Vakuum getrocknet. Ausbeute: 63 g (170 mmol), 98 % d. Th.; Reinheit: 98 % nach ¹H-NMR.

### b) Synthese von 2-(4,6-Diphenyl-1,3,5-triazin-2-yl)-spiro-9,9'-bifluoren

Die Synthese wird analog Beispiel 1 durchgeführt, wobei der 2',7'-Di-*tert-*butyl-spiro-9,9'-bifluoren-2,7-bis(boronsäureglycolester) durch 28 g (50 mmol) Spiro-9,9'-bifluoren-2-boronsäure ersetzt wird. Die Ausbeute beträgt 38 g (41.5 mmol), entsprechend 95.0 % der Theorie.

### Beispiel 4: Herstellung und Charakterisierung von organischen Elektrolumineszenzvorrichtungen enthaltend Triazinverbindungen

Erfindungsgemäße Elektrolumineszenzvorrichtungen können, wie beispielsweise in WO 05/003253 beschrieben, dargestellt werden. Hier werden die Ergebnisse verschiedener OLEDs gegenübergestellt. Der grundlegende Aufbau, die verwendeten Materialien, der Dotierungsgrad und ihre Schichtdicken sind zur besseren Vergleichbarkeit identisch.

Beispiele 5-7, 12 und 15 beschreiben Vergleichsstandards nach dem Stand der Technik, bei denen die Emissionsschicht aus dem Wirtsmaterial (bzw. Matrixmaterial) Bis(9,9'-spirobifluoren-2-yl)keton (SK) oder BAlq oder einer 50:50 Mischung SK:CBP und verschiedenen Gastmaterialien (Dotanden) TER für rote bzw. TEG für grüne Triplettemission besteht. Des Weiteren werden OLEDs, die die Fluorentriazinderivate bzw. Spirobifluorentriazinderivate als Wirtsmaterial enthalten, beschrieben. Analog dem o. g. allgemeinen Verfahren werden die OLEDs mit folgendem Aufbau erzeugt:
- Lochinjektionsschicht (HIL): 20 nm 2,2',7,7'-Tetrakis(di-para-tolylamino)spiro-9,9'-bifluoren
- Lochtransportschicht (HTL): 20 nm NPB (N-Naphthyl-N-phenyl-4,4'-diaminobiphenyl).
- Emissionsschicht (EML): 40 nm Wirtsmaterial: Spiro-Keton (SK) (Bis(9,9'-spirobifluoren-2-yl)keton) oder BAIq (1,1'-Biphenyl-4'-oxy)bis(8-hydroxy-2-methylquinolinato)aluminum) oder SK und CBP (4,4'-Bis(carbazol-9-yl)biphenyl) zu gleichen Anteilen gemischt als Vergleich oder erfindungsgemäße Verbindungen. Dotand: 15 Vol.-% Dotierung; Verbindungen siehe unten.
- Lochblockierschicht (HBL): 10 nm SK (optional)
- Elektronenleiter (ETL): 20 nm AlQ₃ (Tris(chinolinato)aluminium(III)).
- Kathode: 1 nm LiF, darauf 100 nm Al.

Die Strukturen von TER-1, TER-2, TEG, SK, BAlq, CBP sind der Übersichtlichkeit halber im Folgenden abgebildet.

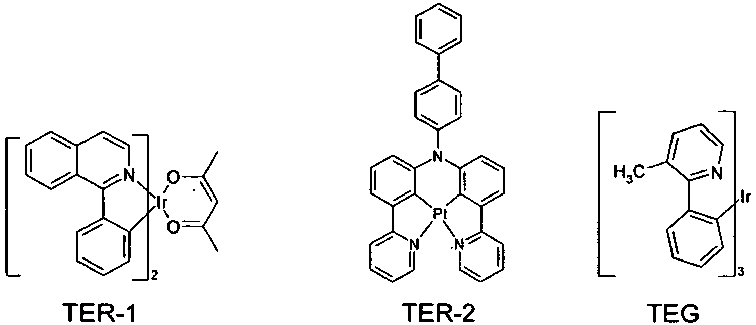

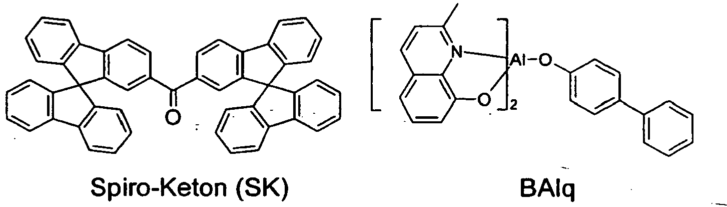

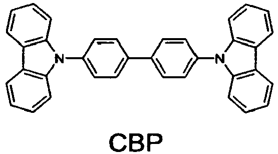

Die verwendeten Triazine TRIAZIN2 und TRIAZIN3 haben die oben in Beispiel 2 und 3 abgebildeten Strukturen.

Diese noch nicht optimierten OLEDs werden standardmäßig charakterisiert; hierfür werden die Elektrolumineszenzspektren, die Effizienz (gemessen in cd/A) in Abhängigkeit von der Helligkeit, die Betriebsspannung, berechnet aus Strom-Spannungs-Helligkeit-Kennlinien (IUL-Kennlinien), und die Lebensdauer bestimmt.

Wie man Tabelle 1 und 3 entnehmen kann, zeigen Devices in den gemessenen Effizienzen, Spannungen und Lebensdauern ein überlegenes Verhalten gegenüber den Vergleichsdevices mit den Wirtsmaterialien SK oder BAlq. Des Weiteren ist in Tabelle 2 zu sehen, dass TRIAZIN2 und TRIAZIN3 sehr gut geeignet sind, um mit carbazolhaltigen Wirtsmaterialien (hier CBP) einen Mischwirt zu bilden.

**Tabelle 1: Device-Ergebnisse mit TRIAZIN2 bzw. TRIAZIN3 in Kombination mit TER-1 bzw. TER-2 als Dotanden**

| Bsp. | EML (kein HBL) | Max. Eff. [cd/A] bei 1000 cd/m² | Spannung [V] bei 1000 cd/m² | CIE (x, y) | Lebensdauer [h], Anfangshelligkeit 1000 cd/m² |
|---|---|---|---|---|---|
| 5 Vergl. | SK : TER-1 | 5.6 | 4.9 | 0.69/ 0.31 | 3000 |
| 6 Vergl. | BAlq: TER-1 | 7.0 | 6.2 | 0.69/ 0.31 | 8500 |
| 7 Vergl. | SK : TER-2 | 6.8 | 5.6 | 0.66/0.33 | 14000 |
| 8 | TRIAZIN2 : TER-1 | 7.5 | 4.8 | 0.68/0.32 | 18000 |
| 9 | TRIAZIN3 : TER-1 | 7.2 | 5.0 | 0.69/0.31 | 14000 |
| 10 | TRIAZIN2 : TER-2 | 9.8 | 6.5 | 0.66/0.33 | 21000 |
| 11 | TRIAZIN3 : TER-2 | 9.0 | 6.5 | 0.66/0.33 | 18000 |

**Tabelle 2: Device-Ergebnisse mit TRIAZIN2 bzw. TRIAZIN3 in Kombination mit CBP und mit TER-1 bzw. TER-2 als Dotanden**

| Bsp. | EML (mit HBL) | Max. Eff. [cd/A] bei 1000 cd/m² | Spannung [V] bei 1000 cd/m² | CIE (x, y) | Lebensdauer [h], Anfangshelligkeit 1000 cd/m² |
|---|---|---|---|---|---|
| 12 Vergl. | SK:CBP:TER-1 | 7.2 | 5.2 | 0.68/0.32 | 7000 |
| 13 | TRIAZIN2 : CBP : TER-1 | 8.0 | 4.7 | 0.68/0.32 | 25000 |
| 14 | TRIAZIN3 : CBP : TER-1 | 8.1 | 5.2 | 0.68/0.32 | 15000 |

**Tabelle 3: Device-Ergebnisse mit TRIAZIN3 in Kombination mit TEG als Dotand**

| Bsp. | EML (mit HBL) | Max. Eff. [cd/A] bei 1000 cd/m² | Spannung [V] bei 1000 cd/m² | CIE (x, y) | Lebensdauer [h], Anfangshelligkeit 1000 cd/m² |
|---|---|---|---|---|---|
| 15 Vergl. | SK: TEG | 27 | 4.2 | 0.36/0.61 | 10000 |
| 16 | TRIAZIN3 : TEG | 35 | 4.7 | 0.36/0.61 | 25000 |

## Patentansprüche

1. Organische Elektrolumineszenzvorrichtung enthaltend in mindestens einer emittierenden Schicht
(A) mindestens eine phosphoreszierende Verbindung, und
(B) mindestens eine Verbindung gemäß Formel (1) oder Formel (2), 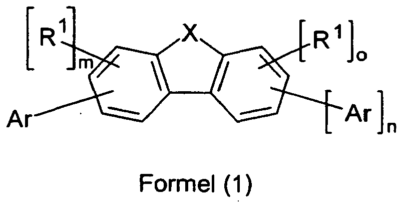 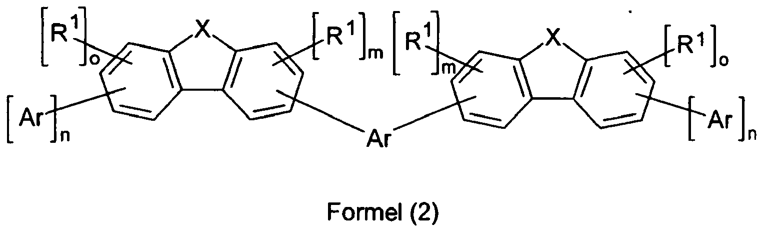 wobei für die verwendeten Symbole und Indizes gilt:
Ar ist bei jedem Auftreten gleich oder verschieden eine Heteroarylgruppe, ausgewählt aus der Gruppe bestehend aus Triazin, Pyrazin, Pyrimidin, Pyridazin, Pyridin, Pyrazol, Imidazol, Oxazol, Oxadiazol oder Thiazol, welche jeweils mit einer oder mehreren Gruppen R¹ substituiert sein kann;
X ist bei jedem Auftreten gleich oder verschieden eine Gruppe gemäß Formel (3), wobei die gestrichelte Bindung jeweils die Bindung an die beiden Benzolringe andeutet: 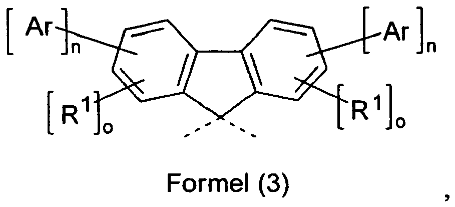 oder X ist bei jedem Auftreten gleich oder verschieden eine bivalente Brücke, ausgewählt aus B(R¹), C(R¹)₂, Si(R¹)₂, C=C(R¹)₂, O, S, S=O, SO₂, N(R¹), P(R¹) und P(=O)R¹;
R¹ ist bei jedem Auftreten gleich oder verschieden H, D, F, Cl, Br, I, CHO, N(Ar¹)₂, C(=O)Ar¹, P(=O)(Ar¹)₂, S(=O)Ar¹, S(=O)₂Ar¹, CR²=CR²Ar¹, CN, NO₂, Si(R²)₃, B(OR²)₂, B(R²)₂, B(N(R²)₂)₂, OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R² substituiert sein kann, wobei eine oder mehrere bevorzugt nicht benachbarte CH₂-Gruppen durch R²C=CR², C=C, Si(R²)₂, Ge(R²)₂, Sn(R²)₂, C=O, C=S, C=Sₑ, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Kombination dieser Systeme; dabei können zwei oder mehrere benachbarte Substituenten R¹ auch miteinander ein mono- oder polycyclisches, aliphatisches oder aromatisches Ringsystem bilden;
Ar¹ ist bei jedem Auftreten gleich oder verschieden ein aromatisches oder heteroaromatisches Ringsystem mit 5 bis 30 aromatischen Ringatomen, das mit einem oder mehreren Resten R² substituiert sein kann; dabei können auch zwei Reste Ar¹, welche an dasselbe Stickstoff-, Phosphor- oder Boratom binden, durch eine Einfachbindung oder eine Brücke, ausgewählt aus B(R²), C(R²)₂, Si(R²)₂, C=O, C=NR², C=C(R²)₂, O, S, S=O, SO₂, N(R²), P(R²) und P(=O)R², miteinander verknüpft sein;
R² ist bei jedem Auftreten gleich oder verschieden H, D oder ein aliphatischer, aromatischer und/oder heteroaromatischer Kohlenwasserstoffrest mit 1 bis 20 C-Atomen, in dem auch H-Atome durch D oder F ersetzt sein können; dabei können zwei oder mehrere benachbarte Substituenten R² auch miteinander ein mono- oder polycyclisches, aliphatisches oder aromatisches Ringsystem bilden;
n ist 0 oder 1;
m ist 0, 1, 2 oder 3;
o ist 0, 1, 2, 3 oder 4, wenn n = 0 ist und ist 0, 1, 2 oder 3, wenn n = 1 ist.

2. Organische Elektrolumineszenzvorrichtung nach Anspruch 1, **dadurch gekennzeichnet, dass** die Verbindung gemäß Formel (1) bzw. Formel (2) ein Fluorenderivat gemäß Formel (4) oder Formel (5) oder ein Spirobifluorenderivat gemäß Formel (6) oder Formel (7) darstellt, 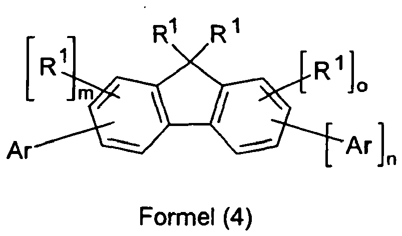 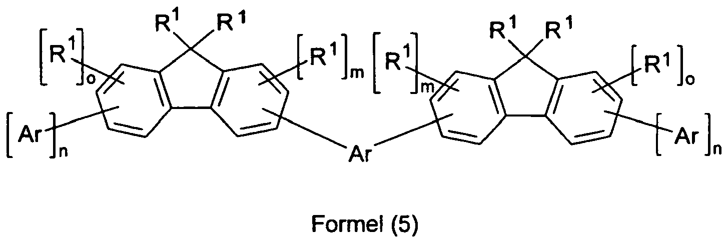 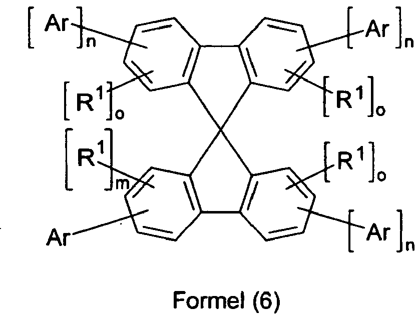 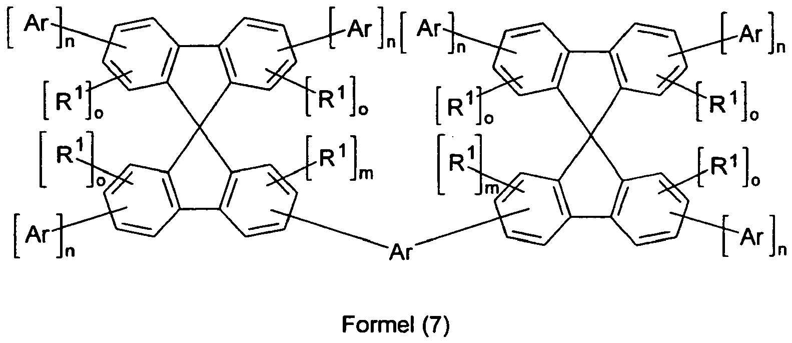 wobei die verwendeten Symbole und Indizes dieselben Bedeutungen haben, wie in Anspruch 1 beschrieben.

3. Organische Elektrolumineszenzvorrichtung nach Anspruch 1 oder 2, **dadurch gekennzeichnet, dass** die monovalente Gruppe Ar ausgewählt ist aus den Gruppen gemäß den Formeln (8) bis (20), wobei die gestrichelte Bindung jeweils die Bindung der Gruppe an das Fluoren bzw. das Spirobifluoren bzw. an das entsprechende heterocyclische Derivat andeutet und R¹ dieselbe Bedeutung hat, wie in Anspruch 1 beschrieben, und dass die bivalente Gruppe Ar in Verbindungen der Formel (2), (5) und (7) ausgewählt ist aus den Gruppen gemäß den Formeln (21) bis (28), wobei die gestrichelten Bindungen jeweils die Bindung der Gruppe an das Fluoren bzw. das Spirobifluoren bzw. an das entsprechende heterocyclische Derivat andeuten und R¹ dieselbe Bedeutung hat, wie in Anspruch 1 beschrieben:

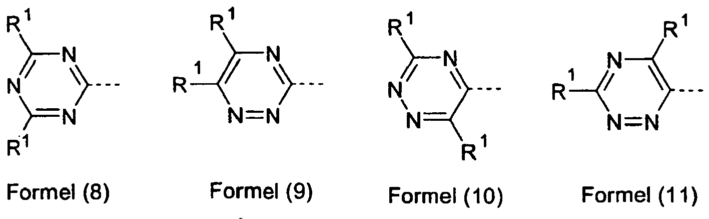

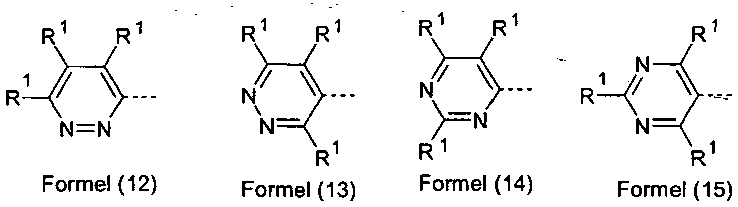

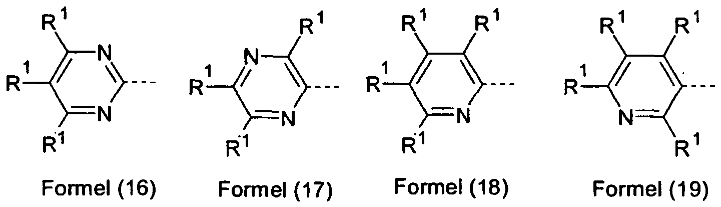

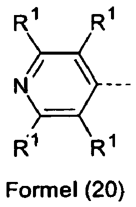

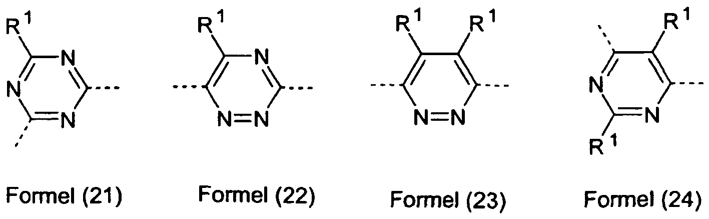

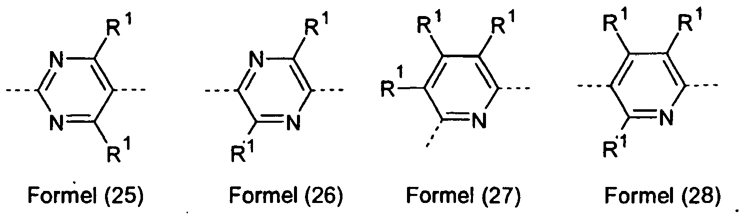

4. Organische Elektrolumineszenzvorrichtung nach Anspruch 3, **dadurch gekennzeichnet, dass** der Rest R¹, welcher an die Gruppen der Formeln (8) bis (28) gebunden ist, gleich oder verschieden bei jedem Auftreten für H oder D, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, wobei ein oder mehrere H-Atome durch D oder F ersetzt sein können, oder ein für aromatisches oder heteroaromatisches Ringsystem mit 5 bis 30 aromatischen Ringatomen, das jeweils durch einen oder mehrere Reste R² substituiert sein kann, oder eine Kombination dieser Systeme steht.

5. Organische Elektrolumineszenzvorrichtung nach einem oder mehreren der Ansprüche 1 bis 4, **dadurch gekennzeichnet, dass** die Verbindung gemäß Formel (1), (2) bzw. (4) bis (5) ausgewählt ist aus Verbindungen gemäß den Formeln (29) bis (32), 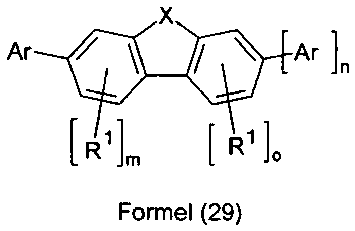 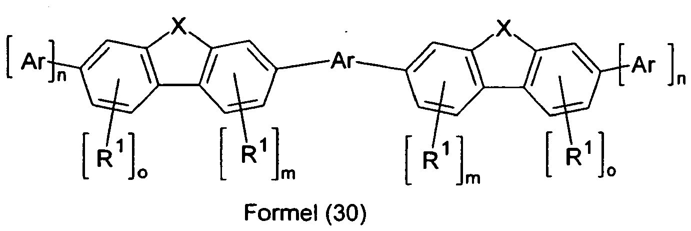 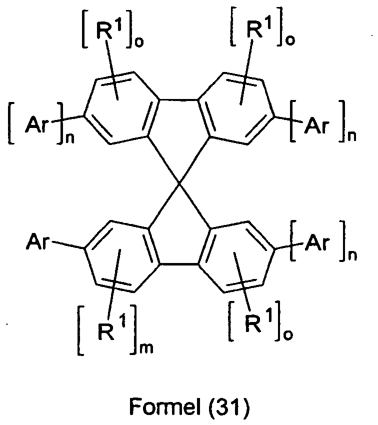 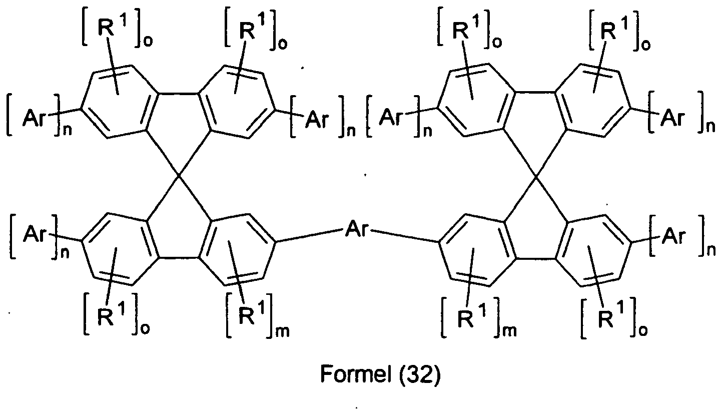 wobei die Symbole und Indizes dieselbe Bedeutung haben, wie in Anspruch 1 beschrieben und wobei für n = 0 in der entsprechenden Position auch ein Substituent R¹ gebunden sein kann.

6. Organische Elektrolumineszenzvorrichtung nach einem oder mehreren der Ansprüche 1 bis 5, **dadurch gekennzeichnet, dass** der Index m = 0 ist und dass an jedem Benzolring die Summe der Indizes n + o = 0 oder 1 ist.

7. Organische Elektrolumineszenzvorrichtung nach einem oder mehreren der Ansprüche 1 bis 6, **dadurch gekennzeichnet, dass** die Verbindung gemäß Formel (1) bzw. Formel (2) ausgewählt ist aus Verbindungen gemäß Formel (33) bis (36), 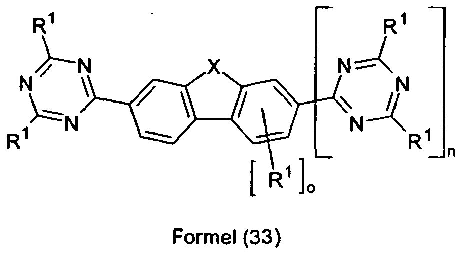 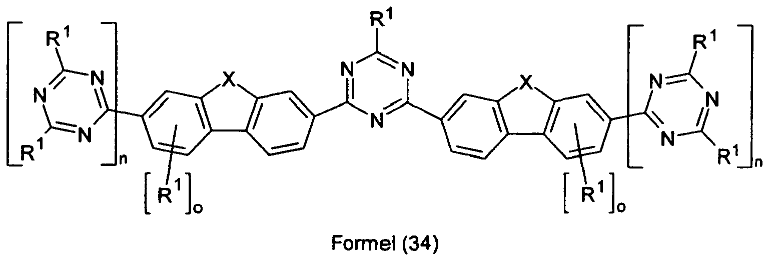 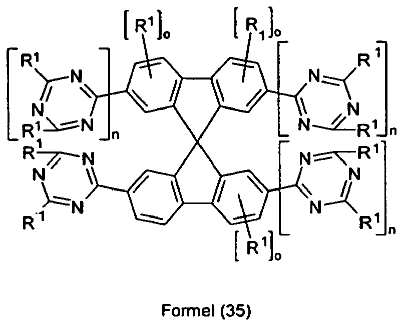 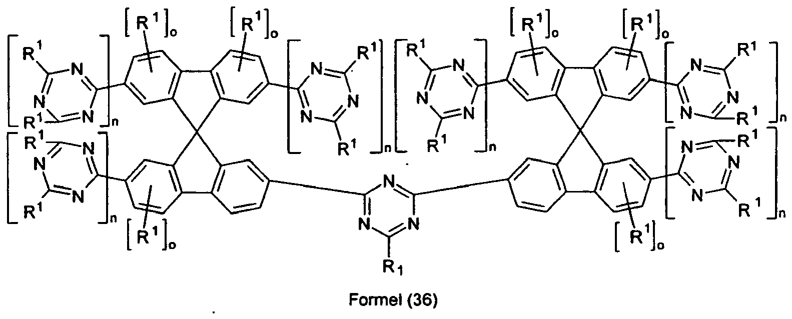 wobei die verwendeten Symbole und Indizes die in Anspruch 1 genannten Bedeutungen haben und weiterhin gilt, dass an jedem Benzolring n + o = 0 oder 1 ist und wobei der Rest R¹ für n = 0 und o = 1 an jeder beliebigen freien Stelle des Benzolrings gebunden sein kann.

8. Organische Elektrolumineszenzvorrichtung nach Anspruch 7, **dadurch gekennzeichnet, dass** Verbindungen der Formeln (35) ausgewählt sind aus Verbindungen gemäß Formel (37), (38) und (39), 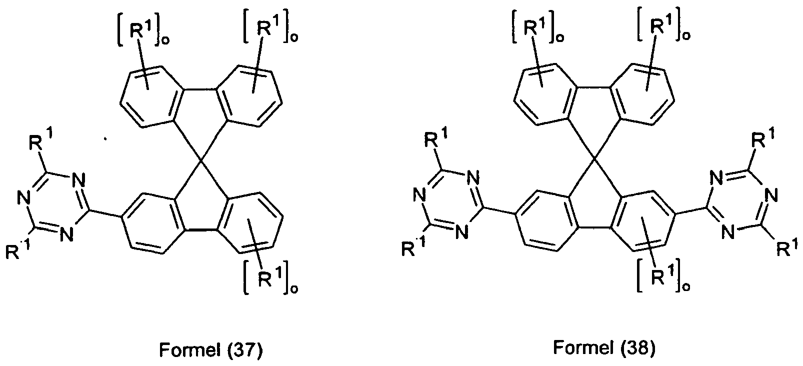 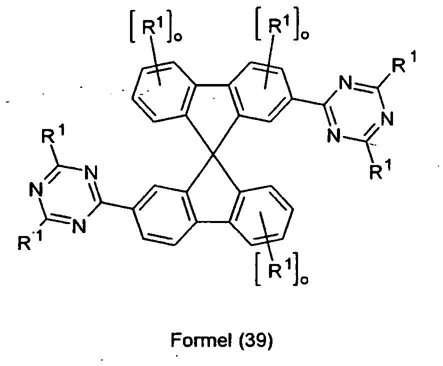 wobei die verwendeten Symbole die oben genannten Bedeutungen haben und o gleich oder verschieden bei jedem Auftreten für 0 oder 1 steht.

9. Organische Elektrolumineszenzvorrichtung nach einem oder mehreren der Ansprüche 1 bis 8, **dadurch gekennzeichnet, dass** die phosphoreszierende Verbindung eine Verbindung ist, die Kupfer, Molybdän, Wolfram, Rhenium, Ruthenium, Osmium, Rhodium, Iridium, Palladium, Platin, Silber, Gold oder Europium enthält, insbesondere eine Verbindung, die Iridium oder Platin enthält.

10. Organische Elektrolumineszenzvorrichtung nach Anspruch 9, **dadurch gekennzeichnet, dass** die phosphoreszierende Verbindung ausgewählt ist aus Verbindungen der Formeln (40) bis (43), 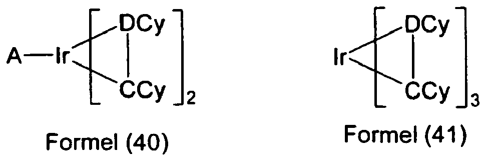 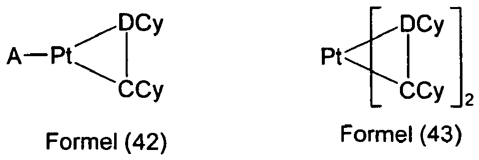 wobei R¹ dieselbe Bedeutung hat, wie in Anspruch 1 beschrieben, und für die weiteren verwendeten Symbole gilt:
DCy ist gleich oder verschieden bei jedem Auftreten eine cyclische Gruppe, die mindestens ein Donoratom, bevorzugt Stickstoff, Kohlenstoff in Form eines Carbens oder Phosphor, enthält, über welches die cyclische Gruppe an das Metall gebunden ist, und die wiederum einen oder mehrere Substituenten R¹ tragen kann; die Gruppen DCy und CCy sind über eine kovalente Bindung miteinander verbunden;
CCy ist gleich oder verschieden bei jedem Auftreten eine cyclische Gruppe, die ein Kohlenstoffatom enthält, über welches die cyclische Gruppe an das Metall gebunden ist und die wiederum einen oder mehrere Substituenten R¹ tragen kann;
A ist gleich oder verschieden bei jedem Auftreten ein monoanionischer, zweizähnig chelatisierender Ligand, bevorzugt ein Diketonatligand.

11. Organische Elektrolumineszenzvorrichtung nach einem oder mehreren der Ansprüche 1 bis 10, **dadurch gekennzeichnet, dass** sie außer Anode, Kathode und mindestens einer emittierenden Schicht weitere Schichten enthält, ausgewählt aus jeweils einer oder mehreren Lochinjektionsschichten, Lochtransportschichten, Lochblockierschichten, Elektronentransportschichten, Elektroneninjektionsschichten, Elektronenblockierschichten, Excitonenblockierschichten, Ladungserzeugungsschichten (=Charge-Generation Layers), Interlayers und/oder organischen oder anorganischen p/n-Übergängen, wobei die Schichten jeweils auch dotiert sein können

12. Organische Elektrolumineszenzvorrichtung nach einem oder mehreren der Ansprüche 1 bis 11, **dadurch gekennzeichnet, dass** die emittierende Schicht außer der phosphoreszierenden Verbindung und der Verbindung gemäß Formel (1) oder (2) noch eine oder mehrere weitere Verbindungen enthält, insbesondere lochtransportierende Verbindungen, bevorzugt ausgewählt aus Triarylaminen, Carbazolderivaten, Azacarbazolen und bipolaren Matrixmaterialien.

13. Verfahren zur Herstellung einer organischen Elektrolumineszenzvorrichtung nach einem oder mehreren der Ansprüche 1 bis 12, **dadurch gekennzeichnet, dass** eine oder mehrere Schichten mit einem Sublimationsverfahren, mit dem OVPD (Organic Vapour Phase Deposition) Verfahren, mit Hilfe einer Trägergassublimation, mit dem OVJP (Organic Vapour Jet Printing) Verfahren, aus Lösung oder mit einem Druckverfahren hergestellt werden.

14. Verwendung von Verbindungen gemäß Formel (1) und (2), wie in Anspruch 1 definiert, als Matrixmaterialien für phosphoreszierende Verbindungen in einer organischen Elektrolumineszenzvorrichtung.

15. Mischung enthaltend mindestens eine Verbindung gemäß Formel (1) oder (2), wie in Anspruch 1 definiert, und mindestens eine phosphoreszierende Verbindung.

16. Lösung enthaltend eine Mischung nach Anspruch 15 sowie mindestens ein organisches Lösungsmittel.

## Claims

1. Organic electroluminescent device comprising, in at least one emitting layer,
(A) at least one phosphorescent compound, and
(B) at least one compound of the formula (1) or formula (2), 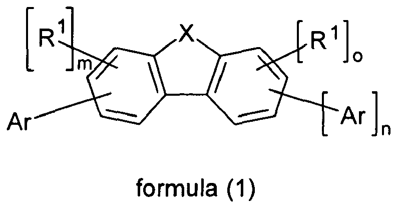 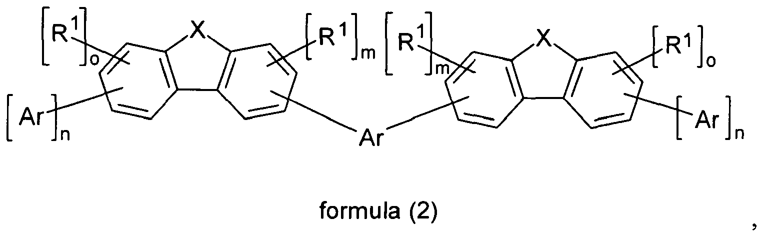 where the following applies to the symbols and indices used:
Ar is on each occurrence, identically or differently, a heteroaryl group selected from the group consisting of triazine, pyrazine, pyrimidine, pyridazine, pyridine, pyrazole, imidazole, oxazole, oxadiazole and thiazole, each of which may be substituted by one or more groups R¹;
X is on each occurrence, identically or differently, a group of the formula (3), where the dashed bond in each case indicates the bonding to the two benzene rings: 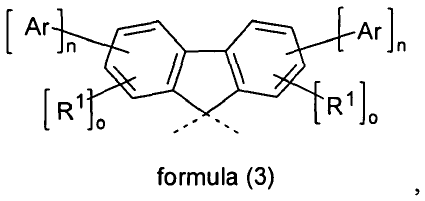 or X is on each occurrence, identically or differently, a divalent bridge selected from B(R¹), C(R¹)₂, Si(R¹)₂, C=C(R¹)₂, O, S, S=O, SO₂, N(R¹), P(R¹) and P(=O)R¹;
R¹ is on each occurrence, identically or differently, H, D, F, Cl, Br, I, CHO, N(Ar¹)₂, C(=O)Ar¹, P(=O)(Ar¹)₂, S(=O)Ar¹, S(=O)₂Ar¹, CR²=CR²Ar¹, CN, NO₂, Si(R²)₃, B(OR²)₂, B(R²)₂, B(N(R²)₂)₂, OSO₂R², a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R², where one or more, preferably non-adjacent CH₂ groups may be replaced by R²C=CR², C=C, Si(R²)₂, Ge(R²)₂, Sn(R²)₂, C=O, C=S, C=Se, C=NR², P(=O)(R²), SO, SO₂, NR², O, S or CONR² and where one or more H atoms may be replaced by D, F, Cl, Br, I, CN or NO₂, or an aromatic or heteroaromatic ring system having 5 to 60 aromatic ring atoms, which may in each case be substituted by one or more radicals R², or an aryloxy or hetero-aryloxy group having 5 to 60 aromatic ring atoms, which may be substituted by one or more radicals R², or a combination of these systems; two or more adjacent substituents R¹ here may also form a mono- or polycyclic, aliphatic or aromatic ring system with one another;
Ar¹ is on each occurrence, identically or differently, an aromatic or heteroaromatic ring system having 5 to 30 aromatic ring atoms, which may be substituted by one or more radicals R²; two radicals Ar¹ here which are bonded to the same nitrogen, phosphorus or boron atom may also be linked to one another by a single bond or a bridge selected from B(R²), C(R²)₂, Si(R²)₂, C=O, C=NR², C=C(R²)₂, O, S, S=O, SO₂, N(R²), P(R²) and P(=O)R²;
R² is on each occurrence, identically or differently, H, D or an aliphatic, aromatic and/or heteroaromatic hydrocarbon radical having 1 to 20 C atoms, in which, in addition, H atoms may be replaced by D or F; two or more adjacent substituents R² here may also form a mono- or polycyclic, aliphatic or aromatic ring system with one another;
n is 0 or 1;
m is 0, 1, 2 or 3;
o is 0, 1, 2, 3 or 4 if n = 0 and is 0, 1,2 or 3 if n=1.

2. Organic electroluminescent device according to Claim 1, **characterised in that** the compound of the formula (1) or formula (2) is a fluorene derivative of the formula (4) or formula (5) or a spirobifluorene derivative of the formula (6) or formula (7), 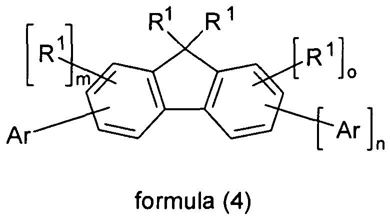 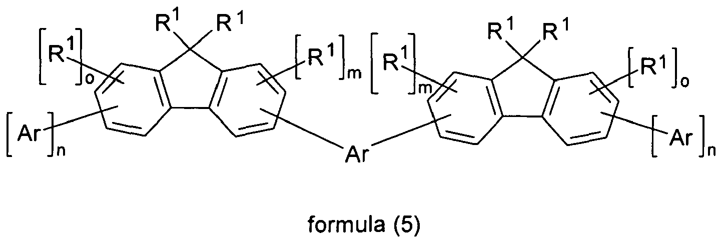 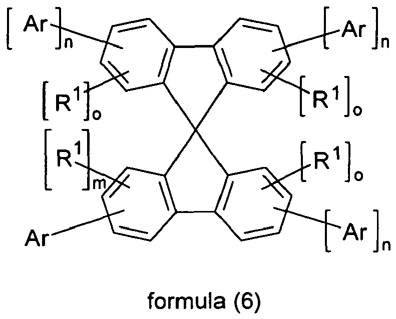 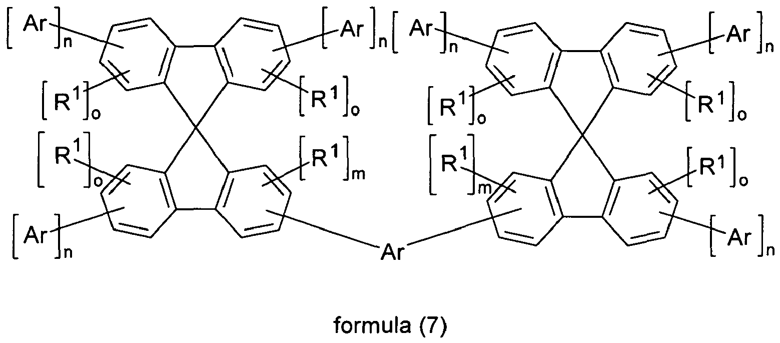 where the symbols and indices used have the same meanings as described in Claim 1.

3. Organic electroluminescent device according to Claim 1 or 2, **characterised in that** the monovalent group Ar is selected from the groups of the formulae (8) to (20), where the dashed bond in each case indicates the bonding of the group to the fluorene or spirobifluorene or to the corresponding heterocyclic derivative, and R¹ has the same meaning as described in Claim 1, and **in that** the divalent group Ar in compounds of the formulae (2), (5) and (7) is selected from the groups of the formulae (21) to (28), where the dashed bonds in each case indicate the bonding of the group to the fluorene or spirobifluorene or to the corresponding heterocyclic derivative, and R¹ has the same meaning as described in Claim 1:

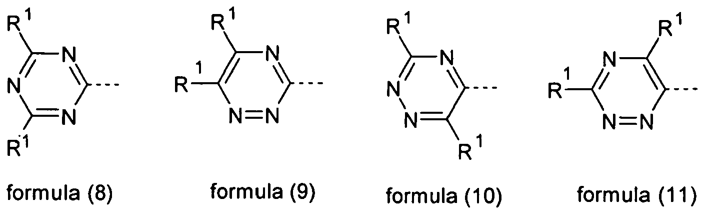

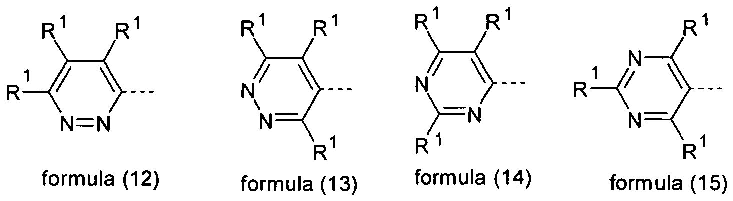

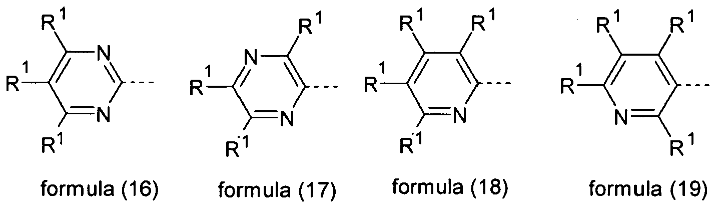

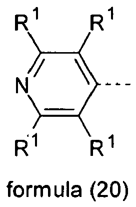

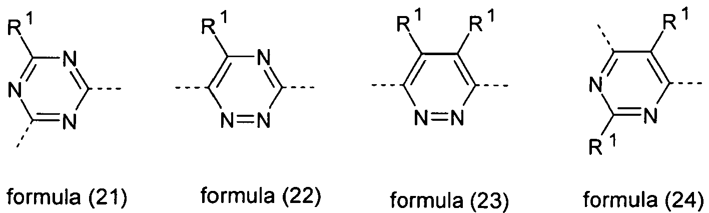

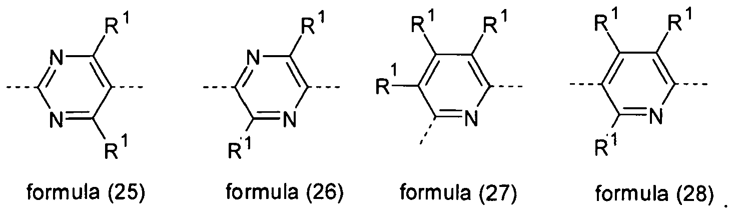

4. Organic electroluminescent device according to Claim 3, **characterised in that** the radical R¹ which is bonded to the groups of the formulae (8) to (28) stands, identically or differently on each occurrence, for H or D, a straight-chain alkyl or alkoxy group having 1 to 10 C atoms or a branched or cyclic alkyl or alkoxy group having 3 to 10 C atoms, each of which may be substituted by one or more radicals R², where one or more H atoms may be replaced by D or F, or for an aromatic or heteroaromatic ring system having 5 to 30 aromatic ring atoms, which may in each case be substituted by one or more radicals R², or a combination of these systems.

5. Organic electroluminescent device according to one or more of Claims 1 to 4, **characterised in that** the compound of the formula (1), (2) or (4) to (5) is selected from compounds of the formulae (29) to (32), 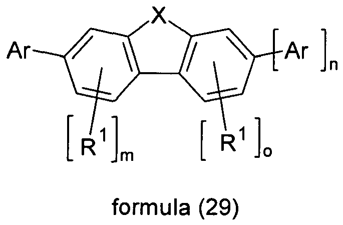 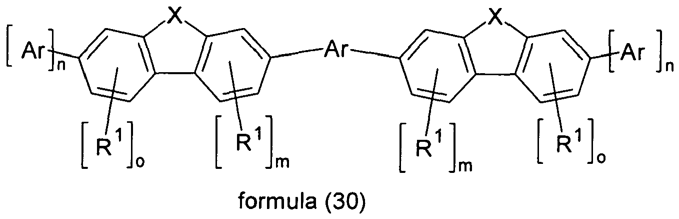 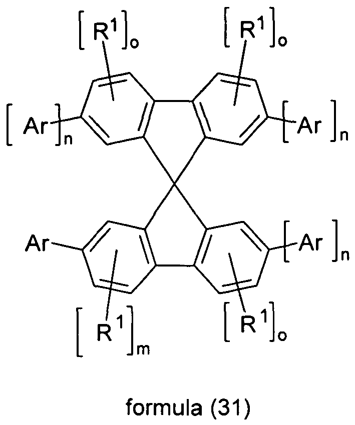 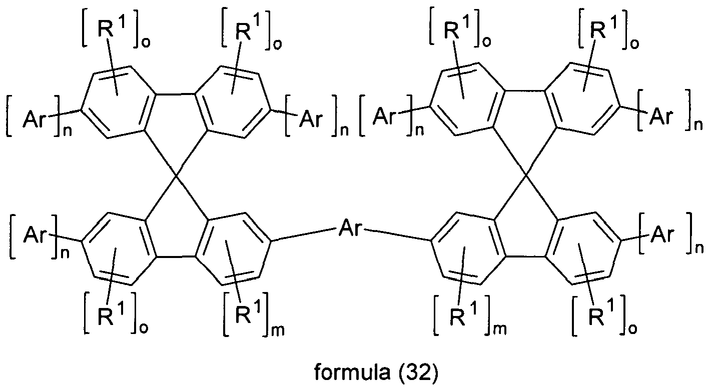 where the symbols and indices have the same meaning as described in Claim 1, and where, for n = 0, a substituent R¹ may also be bonded in the corresponding position.

6. Organic electroluminescent device according to one or more of Claims 1 to 5, **characterised in that** the index m = 0, and **in that** the sum of the indices n + o = 0 or 1 on each benzene ring.

7. Organic electroluminescent device according to one or more of Claims 1 to 6, **characterised in that** the compound of the formula (1) or formula (2) is selected from compounds of the formulae (33) to (36), 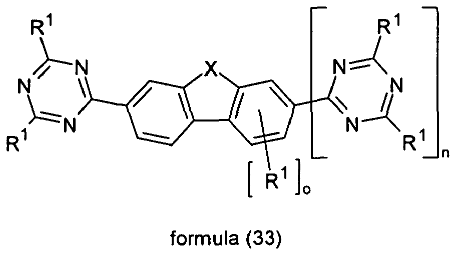 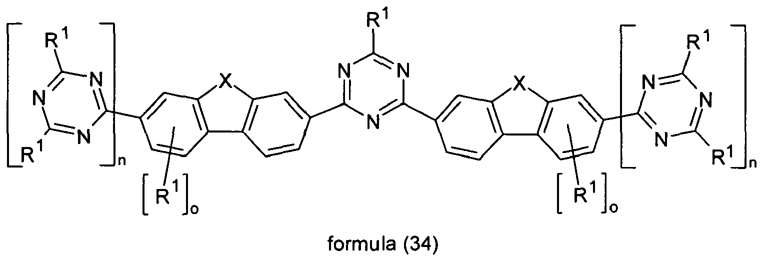 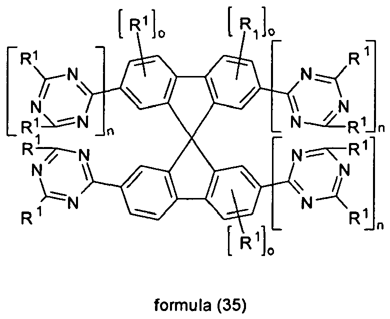 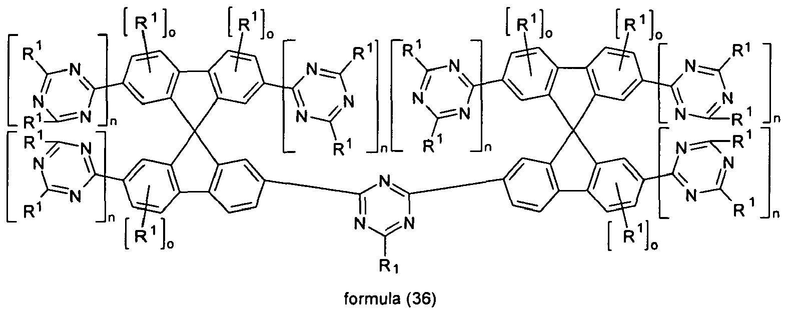 where the symbols and indices used have the meanings mentioned in Claim 1, and furthermore n + o = 0 or 1 on each benzene ring, and where, for n = 0 and o = 1, the radical R¹ may be bonded to any desired free site on the benzene ring.

8. Organic electroluminescent device according to Claim 7, **characterised in that** compounds of the formula (35) are selected from compounds of the formulae (37), (38) and (39), 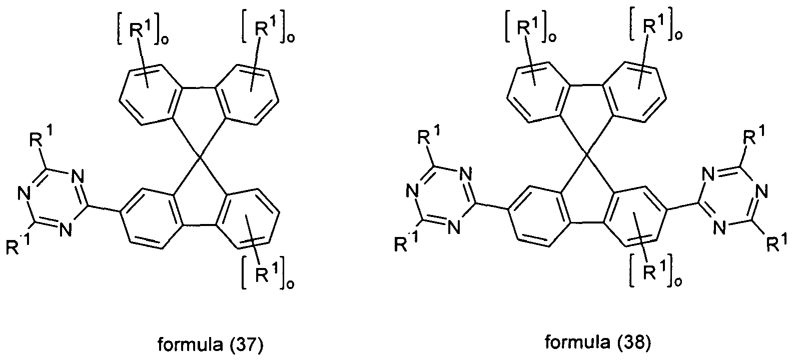 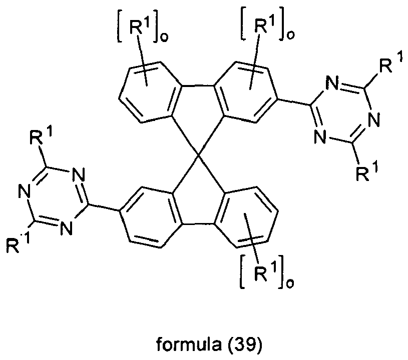 where the symbols used have the meanings mentioned above, and o stands, identically or differently on each occurrence, for 0 or 1.

9. Organic electroluminescent device according to one or more of Claims 1 to 8, **characterised in that** the phosphorescent compound is a compound which contains copper, molybdenum, tungsten, rhenium, ruthenium, osmium, rhodium, iridium, palladium, platinum, silver, gold or europium, in particular a compound which contains iridium or platinum.

10. Organic electroluminescent device according to Claim 9, **characterised in that** the phosphorescent compound is selected from compounds of the formulae (40) to (43), 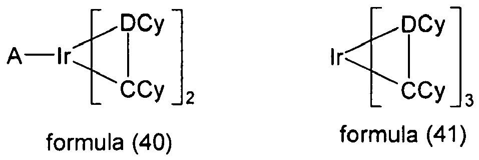 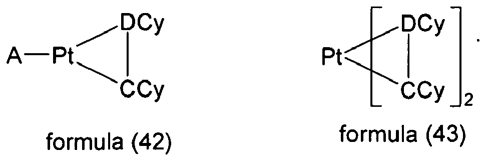 where R¹ has the same meaning as described in Claim 1, and the following applies to the other symbols used:
DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents R¹; the groups DCy and CCy are connected to one another via a covalent bond;
CCy is, identically or differently on each occurrence, a cyclic group which contains a carbon atom via which the cyclic group is bonded to the metal and which may in turn carry one or more substituents R¹;
A is, identically or differently on each occurrence, a monoanionic, bidentate chelating ligand, preferably a diketonate ligand.

11. Organic electroluminescent device according to one or more of Claims 1 to 10, **characterised in that**, apart from the anode, cathode and at least one emitting layer, it comprises further layers selected from in each case one or more hole-injection layers, hole-transport layers, hole-blocking layers, electron-transport layers, electron-injection layers, electron-blocking layers, exciton-blocking layers, charge-generation layers, interlayers and/or organic or inorganic p/n junctions, where the layers may in each case also be doped.

12. Organic electroluminescent device according to one or more of Claims 1 to 11, **characterised in that** the emitting layer, in addition to the phosphorescent compound and the compound of the formula (1) or (2), also comprises one or more further compounds, in particular hole-transporting compounds, preferably selected from triarylamines, carbazole derivatives, azacarbazoles and bipolar matrix materials.

13. Process for the production of an organic electroluminescent device according to one or more of Claims 1 to 12, **characterised in that** one or more layers are produced by means of a sublimation process, by means of the OVPD (organic vapour phase deposition) process, with the aid of carrier-gas sublimation, by means of the OVJP (organic vapour jet printing) process, from solution or by means of a printing process.

14. Use of compounds of the formulae (1) and (2) as defined in Claim 1 as matrix materials for phosphorescent compounds in an organic electroluminescent device.

15. Mixture comprising at least one compound of the formula (1) or (2) as defined in Claim 1 and at least one phosphorescent compound.

16. Solution comprising a mixture according to Claim 15 and at least one organic solvent.

## Revendications

1. Dispositif électroluminescent organique comprenant, dans au moins une couche d'émission,
(A) au moins un composé phosphorescent, et
(B) au moins un composé de la formule (1) ou de la formule (2), 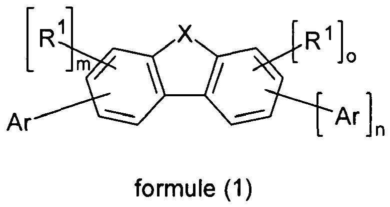 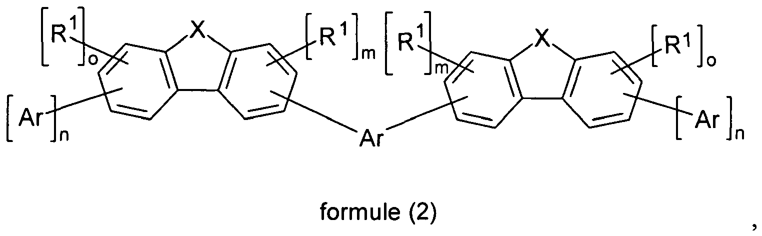 où ce qui suit s'applique aux symboles et indices utilisés :
Ar est, pour chaque occurrence, de manière identique ou différente, un groupe hétéroaryle choisi parmi le groupe constitué par triazine, pyrazine, pyrimidine, pyridazine, pyridine, pyrazole, imidazole, oxazole, oxadiazole et thiazole, dont chacun peut être substitué par un ou plusieurs groupes R¹ ;
X est, pour chaque occurrence, de manière identique ou différente, un groupe de la formule (3), où la liaison en pointillés indique dans chaque cas la liaison sur les deux cycles benzène 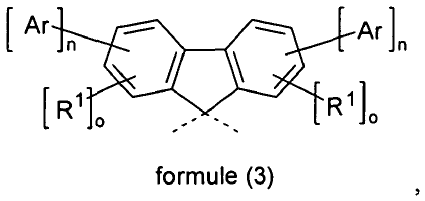 ou X est, pour chaque occurrence, de manière identique ou différente, un pont divalent choisi parmi B(R¹), C(R¹)₂, Si(R¹)₂, C=C(R¹)₂, O, S, S=O, SO₂, N(R¹), P(R¹) et P(=O)R¹ ;
R¹ est, pour chaque occurrence, de manière identique ou différente, H, D, F, Cl, Br, I, CHO, N(Ar¹)₂, C(=O)Ar¹, P(=O)(Ar¹)₂, S(=O)Ar¹, S(=O)₂Ar¹, CR²=CR²Aᵣ¹, CN, NO₂, Si(R²)_{3,} B(OR²)_{2,} B(R²)₂, B(N(R²)₂)₂, OSO₂R², un groupe alkyl, alcoxy ou thioalcoxy en chaîne droite comportant de 1 à 40 atomes de C ou un groupe alkényle ou alkynyle en chaîne droite comportant de 2 à 40 atomes de C ou un groupe alkyle, alkényle, alkynyle, alcoxy ou thioalcoxy ramifié ou cyclique comportant de 3 à 40 atomes de C, dont chacun peut être substitué par un ou plusieurs radicaux R², où un ou plusieurs groupes CH₂, de préférence non adjacents, peut/peuvent être remplacé(s) par R²C=CR², C≡C, Si(R²)₂, Ge(R²)₂, Sn(R²)₂, C=O, C=S, C=Se, C=NR², P(=O)(R²), SO, SO₂, NR², O, S ou CONR² et où un ou plusieurs atomes de H peut/peuvent être remplacé(s) par D, F, Cl, Br, I, CN ou NO₂, ou un système de cycle aromatique ou hétéroaromatique comportant de 5 à 60 atomes de cycle aromatique, lesquels peuvent dans chaque cas être substitués par un ou plusieurs radicaux R², ou un groupe aryloxy ou hétéro-aryloxy comportant de 5 à 60 atomes de cycle aromatique, lesquels peuvent être substitués par un ou plusieurs radicaux R², ou une combinaison de ces systèmes ; deux substituants R¹ adjacents ou plus peuvent ici également former un système de cycle aliphatique ou aromatique monocyclique ou polycyclique l'un avec l'autre ou les uns avec les autres ;
Ar¹ est, pour chaque occurrence, de manière identique ou différente, un système de cycle aromatique ou hétéroaromatique comportant de 5 à 30 atomes de cycle aromatique, lesquels peuvent être substitués par un ou plusieurs radicaux R²; deux radicaux Ar¹ qui ici sont liés au même atome d'azote, de phosphore ou de bore peuvent également être liés l'un à l'autre par une liaison simple ou un pont choisi parmi B(R²), C(R²)₂, Si(R²)₂, C=O, C=NR², C=C(R²)₂, O, S, S=O, SO₂, N(R²), P(R²) et P(=O)R² ;
R² est, pour chaque occurrence, de manière identique ou différente, H, D ou un radical hydrocarbone aliphatique, aromatique et/ou hétéroaromatique comportant de 1 à 20 atomes de C, où, en outre, des atomes de H peuvent être remplacés par D ou F ; deux substituants R² adjacents ou plus peuvent ici également former un système de cycle aliphatique ou aromatique monocyclique ou polycyclique l'un avec l'autre ou les uns avec les autres ;
n est 0 ou 1 ;
m est 0, 1, 2 ou 3 ;
o est 0, 1, 2, 3 ou 4 si n = 0 et est 0, 1, 2 ou 3 si n = 1.

2. Dispositif électroluminescent organique selon la revendication 1, **caractérisé en ce que** le composé de la formule (1) ou de la formule (2) est un dérivé de fluorène de la formule (4) ou de la formule (5) ou un dérivé de spirobifluorène de la formule (6) ou de la formule (7), 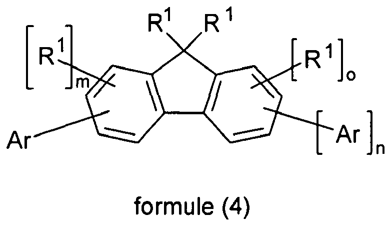 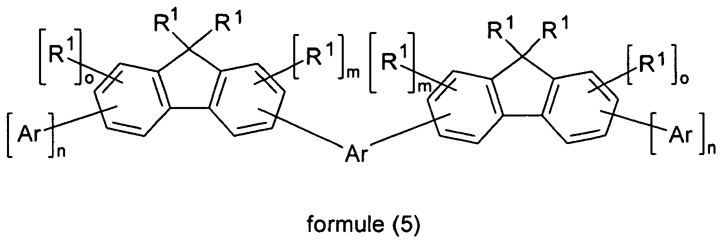 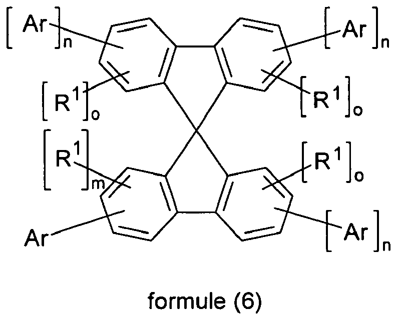 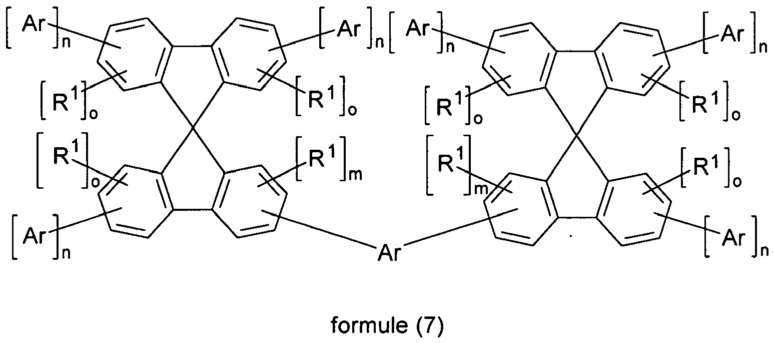 où les symboles et indices utilisés présentent les mêmes significations que décrit selon la revendication 1.

3. Dispositif électroluminescent organique selon la revendication 1 ou 2, **caractérisé en ce que** le groupe monovalent Ar est choisi parmi les groupes des formules (8) à (20), où la liaison en pointillés indique dans chaque cas la liaison du groupe sur le fluorène ou le spirobifluorène ou sur le dérivé hétérocyclique correspondant, et R¹ présente la même signification que décrit selon la revendication 1, et **en ce que** le groupe divalent Ar dans des composés des formules (2), (5) et (7) est choisi parmi les groupes des formules (21) à (28), où la liaison en pointillés indique dans chaque cas la liaison du groupe sur le fluorène ou le spirobifluorène ou sur le dérivé hétérocyclique correspondant, et R¹ présente la même signification que décrit selon la revendication 1 :

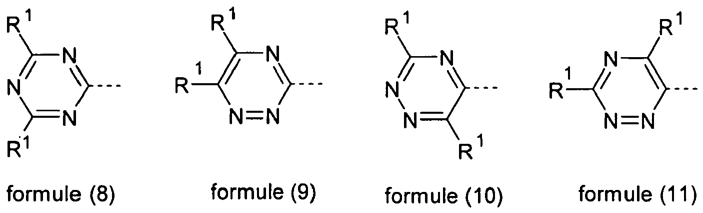

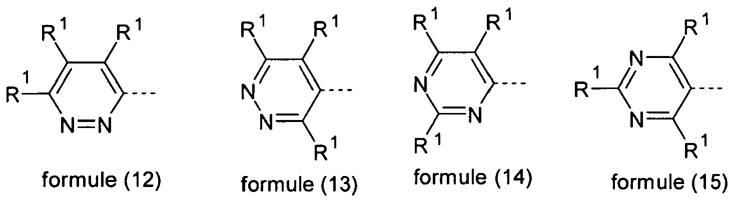

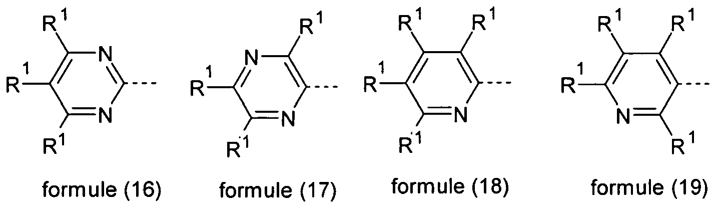

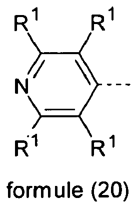

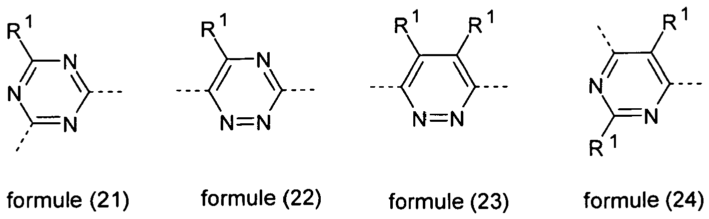

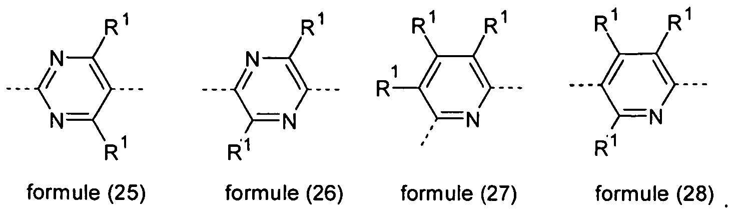

4. Dispositif électroluminescent organique selon la revendication 3, **caractérisé en ce que** le radical R¹ qui est lié aux groupes des formules (8) à (28) représente, de manière identique ou différente pour chaque occurrence, pour H ou D, un groupe alkyle ou alcoxy en chaîne droite comportant de 1 à 10 atomes de C ou un groupe alkyle ou alcoxy ramifié ou cyclique comportant de 3 à 10 atomes de C, dont chacun peut être substitué par un ou plusieurs radicaux R², où un ou plusieurs atomes de H peut/peuvent être remplacé(s) par D ou F, ou pour un système de cycle aromatique ou hétéroaromatique comportant de 5 à 30 atomes de cycle aromatique, lesquels peuvent dans chaque cas être substitués par un ou plusieurs radicaux R², ou une combinaison de ces systèmes.

5. Dispositif électroluminescent organique selon une ou plusieurs des revendications 1 à 4, **caractérisé en ce que** le composé de la formule (1), (2) ou (4) à (5) est choisi parmi des composés des formules (29) à (32), 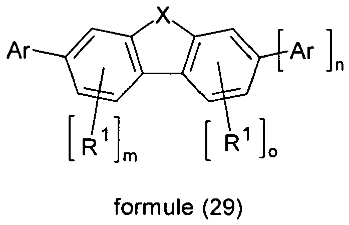 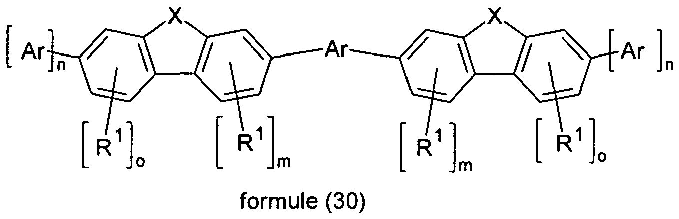 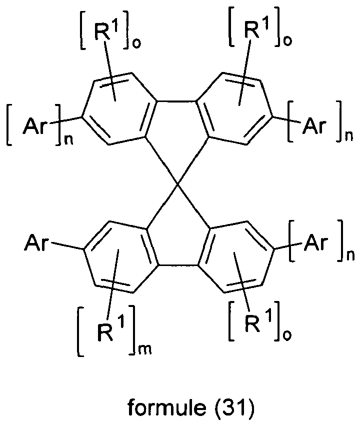 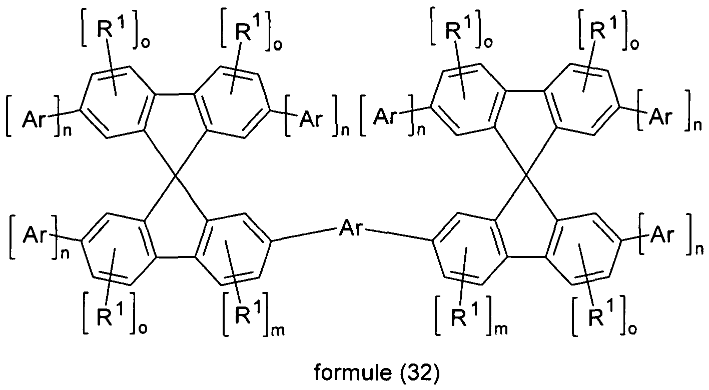 où les symboles et indices présentent la même signification que décrit selon la revendication 1, et où, pour n = 0, un substituant R¹ peut également être lié au niveau de la position correspondante.

6. Dispositif électroluminescent organique selon une ou plusieurs des revendications 1 à 5, **caractérisé en ce que** l'indice m = 0, et **en ce que** la somme des indices n + o = 0 ou 1 pour chaque cycle benzène.

7. Dispositif électroluminescent organique selon une ou plusieurs des revendications 1 à 6, **caractérisé en ce que** le composé de la formule (1) ou de la formule (2) est choisi parmi des composés des formules (33) à (36), 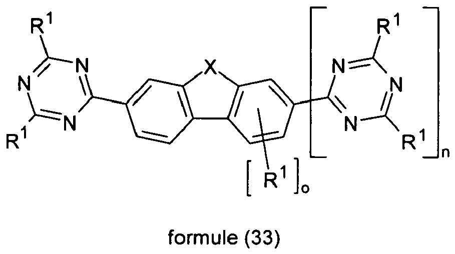 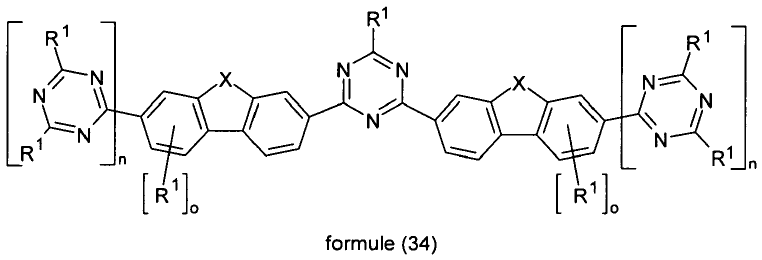 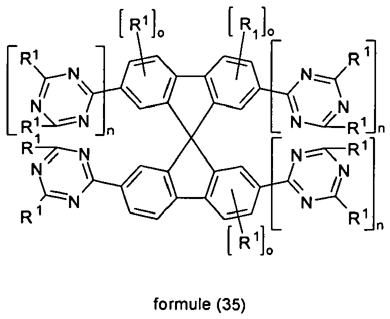 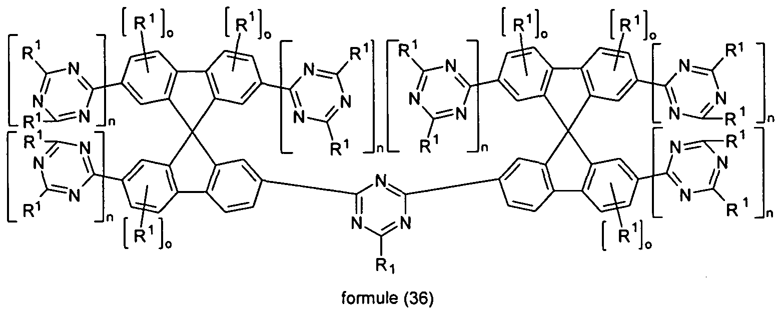 où les symboles et indices utilisés présentent les significations mentionnées selon la revendication 1, et en outre n + o = 0 ou 1 pour chaque cycle benzène, et où, pour n = 0 et o = 1, le radical R¹ peut être lié sur n'importe quel site libre souhaité sur le cycle benzène.

8. Dispositif électroluminescent organique selon la revendication 7, **caractérisé en ce que** des composés de la formule (35) sont choisis parmi des composés des formules (37), (38) et (39), 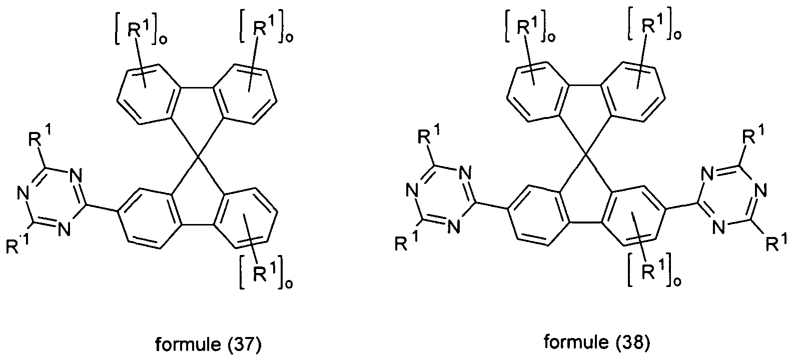 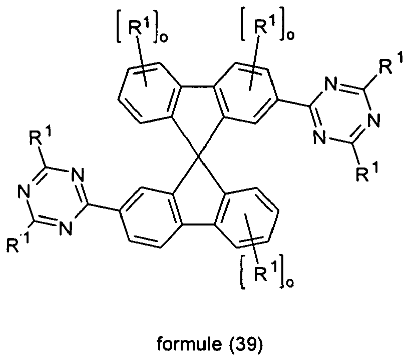 où les symboles utilisés présentent les significations mentionnées avant, et o représente, de manière identique ou différente pour chaque occurrence, 0 ou 1.

9. Dispositif électroluminescent organique selon une ou plusieurs des revendications 1 à 8, **caractérisé en ce que** le composé phosphorescent est un composé qui contient du cuivre, du molybdène, du tungstène, du rhénium, du ruthénium, de l'osmium, du rhodium, de l'iridium, du palladium, du platine, de l'argent, de l'or ou de l'europium, en particulier un composé qui contient de l'iridium ou du platine.

10. Dispositif électroluminescent organique selon la revendication 9, **caractérisé en ce que** le composé phosphorescent est choisi parmi des composés des formules (40) à (43), 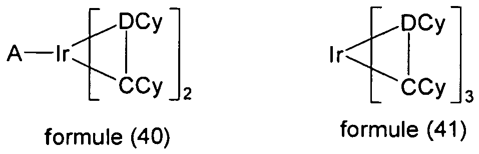 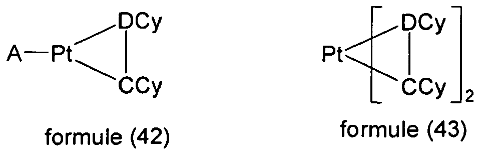 où R¹ présente la même signification que décrit selon la revendication 1, et ce qui suit s'applique aux autres symboles utilisés :
DCy est, de manière identique ou différente pour chaque occurrence, un groupe cyclique qui contient au moins un atome de donneur, de préférence de l'azote, du carbone sous la forme d'un carbène ou du phosphore, via lequel le groupe cyclique est lié au métal, et lequel peut à son tour porter un ou plusieurs substituants R¹ ; les groupes DCy et CCy sont connectés l'un à l'autre via une liaison covalente ;
CCy est, de manière identique ou différente pour chaque occurrence, un groupe cyclique qui contient un atome de carbone via lequel le groupe cyclique est lié au métal et lequel peut à son tour porter un ou plusieurs substituants R¹;
A est, de manière identique ou différente pour chaque occurrence, un ligand chélatant, bidenté, monoanionique, de préférence un ligand dicétonate.

11. Dispositif électroluminescent organique selon une ou plusieurs des revendications 1 à 10, **caractérisé en ce que**, indépendamment de l'anode, de la cathode et d'au moins une couche d'émission, il comprend d'autres couches choisies parmi, dans chaque cas, une ou plusieurs couches prises parmi des couches d'injection de trous, des couches de transport de trous, des couches de blocage de trous, des couches de transport d'électrons, des couches d'injection d'électrons, des couches de blocage d'électrons, des couches de blocage d'excitons, des couches de génération de charges, des intercouches et/ou des jonctions p/n organiques ou inorganiques, où les couches peuvent dans chaque cas être également dopées.

12. Dispositif électroluminescent organique selon une ou plusieurs des revendications 1 à 11, **caractérisé en ce que** la couche d'émission, en plus du composé phosphorescent et du composé de la formule (1) ou (2), comprend également un ou plusieurs autres composés, en particulier des composés de transport de trous, de préférence choisis parmi des triarylamines, des dérivés de carbazole, des azacarbazoles et des matériaux matriciels bipolaires.

13. Procédé pour la production d'un dispositif électroluminescent organique selon une ou plusieurs des revendications 1 à 12, **caractérisé en ce qu'**une ou plusieurs couches sont produites au moyen d'un procédé de sublimation, au moyen du procédé OVPD (dépôt organique en phase vapeur), à l'aide d'une sublimation par gaz porteur, au moyen du procédé OVJP (impression organique par jet de vapeur), à partir d'une solution ou au moyen d'un procédé d'impression.

14. Utilisation de composés des formules (1) et (2) comme défini selon la revendication 1 en tant que matériaux matriciels pour des composés phosphorescents dans un dispositif électroluminescent organique.

15. Mélange comprenant au moins un composé de la formule (1) ou (2) comme défini selon la revendication 1 et au moins un composé phosphorescent.

16. Solution comprenant un mélange selon la revendication 15 et au moins un solvant organique.
